# EUROPEAN PATENT APPLICATION

(11) **EP 4 815 318 A1**
(43) Date of publication of application: **30.09.2026**
(21) Application number: 24916288.4
(22) Date of filing: 07.06.2024
(51) Int. Cl.: H04B 1/10

(54) **POWER SUPPLY AND LOAD CHANGEOVER CIRCUIT, LOW-NOISE AMPLIFIER AND ELECTRONIC DEVICE**

(30) Priority: 10.01.2024 CN 202410033939
(71) Applicant: Honor Device Co., Ltd., Shenzhen, Guangdong 518040 (CN)
(72) Inventor: SUN, Jiangtao, Shenzhen, Guangdong 518040 (CN); HUANG, Qinghua, Shenzhen, Guangdong 518040 (CN); AN, Yang, Shenzhen, Guangdong 518040 (CN); MEI, Zheng, Shenzhen, Guangdong 518040 (CN)
(74) Representative: Isarpatent
(86) International application number: PCT/CN2024/098255
(87) International publication number: WO 2025/148232

(57) **Abstract**

This application discloses a power supply and load switching circuit, a low noise amplifier, and an electronic device, which relates to the field of electronic device technologies. The power supply and load switching circuit includes at least two power supplies, a toggle switch, at least two loads, and at least two output ports. At least two ports of the toggle switch are respectively electrically connected to the at least two power supplies, and at least two other ports of the toggle switch are respectively electrically connected to the at least two output ports, to switch on at least four power paths. The at least two loads are respectively arranged on paths between the at least two power supplies and the at least two output ports, to adjust load impedance values of the at least four power paths. Based on the solution in this application, linearity, power consumption, and an operating band of the low noise amplifier may be adjusted, to enable the low noise amplifier to obtain more different performance modes.

## Description

This application claims priority to Chinese Patent Application No. 202410033939.1, entitled "POWER SUPPLY AND LOAD SWITCHING CIRCUIT, LOW NOISE AMPLIFIER, AND ELECTRONIC DEVICE" and filed with the China National Intellectual Property Administration on January 10, 2024, which is incorporated herein by reference in its entirety.

### TECHNICAL FIELD

This application relates to the field of electronic device technologies, and specifically, to a power supply and load switching circuit, a low noise amplifier, and an electronic device.

### BACKGROUND

In a radio frequency receive link to which wireless communication such as cellular communication, wireless fidelity (wireless fidelity, WIFI), or satellite communication is applied, a low noise amplifier is generally used to receive designated downlink signals from various complex environments. In a process in which the low noise amplifier receives the downlink signals, generally, there are different performance requirements for different application scenarios. For example, in a satellite communication application scenario, there is a high requirement on linearity and noise; and in a cellular communication application scenario, there is a high requirement on noise and power consumption.

Currently, the linearity and power consumption of the low noise amplifier are adjusted generally in a manner of switching two power supplies, and there are few adjustable performance modes, which cannot satisfy requirements of more application scenarios of the low noise amplifier.

Therefore, a technical solution is urgently needed to resolve the foregoing problem.

### SUMMARY

This application provides a power supply and load switching circuit, a low noise amplifier, and an electronic device. Linearity, power consumption, and an operating band of the low noise amplifier are adjusted by switching a plurality of power supplies and a plurality of loads, to enable the low noise amplifier to obtain more different performance modes.

To achieve the foregoing objective, the following technical solutions are used in this application.

According to a first aspect, a power supply and load switching circuit is provided, including at least two power supplies, a toggle switch, at least two loads, and at least two output ports, where at least two ports of the toggle switch are respectively electrically connected to the at least two power supplies, and at least two other ports of the toggle switch are respectively electrically connected to the at least two output ports, to switch on at least four power paths; and the at least two loads are respectively arranged on paths between the at least two power supplies and the at least two output ports, to adjust load impedance values of the at least four power paths.

In embodiments of this application, at least four performance modes with different linearity and power consumption may be obtained by switching different power paths of the at least two power supplies, and at least two performance modes with different operating bands may be obtained by switching different impedance values of the at least two loads, to enable the low noise amplifier to obtain more different performance modes.

With reference to the first aspect, in some implementations of the first aspect, the at least two loads include a first load inductor and a second load inductor; and the first load inductor and the second load inductor are respectively arranged on paths between the at least two power supplies and the toggle switch.

In the implementations, the first load inductor and the second load inductor are respectively arranged on the paths between the at least two power supplies and the toggle switch, so that impedance values between the at least two power supplies and the toggle switch may be adjusted, thereby adjusting an operating band of the low noise amplifier, to enable the low noise amplifier to obtain more different performance modes.

Optionally, an inductance value of the first load inductor and an inductance value of the second load inductor may be the same or may be different.

With reference to the first aspect, in some implementations of the first aspect, a coupling relationship exists between the first load inductor and the second load inductor.

In the implementations, when the coupling relationship exists between the first load inductor and the second load inductor, the impedance values between the at least two power supplies and the toggle switch may be adjusted again, thereby adjusting the operating band of the low noise amplifier again, to enable the low noise amplifier to obtain more different performance modes.

With reference to the first aspect, in some implementations of the first aspect, the at least two loads include a third load inductor and a fourth load inductor; and the third load inductor and the fourth load inductor are respectively arranged on paths between the toggle switch and the at least two output ports.

Optionally, an inductance value of the third load inductor and an inductance value of the fourth load inductor may be the same or may be different.

In the implementations, the third load inductor and the fourth load inductor are respectively arranged on the paths between the toggle switch and the at least two output ports, so that impedance values between the toggle switch and the at least two output ports may be adjusted, thereby adjusting the operating band of the low noise amplifier, to enable the low noise amplifier to obtain more different performance modes.

With reference to the first aspect, in some implementations of the first aspect, a coupling relationship exists between the third load inductor and the fourth load inductor.

In the implementations, when the coupling relationship exists between the third load inductor and the fourth load inductor, the impedance values between the toggle switch and the at least two output ports may be adjusted again, thereby adjusting the operating band of the low noise amplifier again, to enable the low noise amplifier to obtain more different performance modes.

With reference to the first aspect, in some implementations of the first aspect, the at least two loads include a first load inductor, a second load inductor, a third load inductor, and a fourth load inductor; and the first load inductor and the second load inductor are respectively arranged on paths between the at least two power supplies and the toggle switch, the third load inductor and the fourth load inductor are respectively arranged on paths between the toggle switch and the at least two output ports, and a coupling relationship exists between any two of the first load inductor, the second load inductor, the third load inductor, and the fourth load inductor.

In the implementations, the first load inductor, the second load inductor, the third load inductor, and the fourth load inductor are respectively arranged on the paths between the at least two power supplies and the at least two output ports, and it is enabled that the coupling relationship exists between any two of the first load inductor, the second load inductor, the third load inductor, and the fourth load inductor, so that impedance values between the at least two power supplies and the at least two output ports may be adjusted, thereby adjusting the operating band of the low noise amplifier, to enable the low noise amplifier to obtain more different performance modes.

Optionally, an inductance value of the first load inductor, an inductance value of the second load inductor, an inductance value of the third load inductor, and an inductance value of the fourth load inductor may be the same or may be different.

With reference to the first aspect, in some implementations of the first aspect, the at least two power supplies include a first power supply and a second power supply; and the first power supply and the second power supply are respectively electrically connected to the at least two ports of the toggle switch, and a voltage value of the first power supply is greater than a voltage value of the second power supply.

In the implementations, because the voltage value of the first power supply and the voltage value of the second power supply are different, the low noise amplifier may obtain more performance modes with different linearity and power consumption.

With reference to the first aspect, in some implementations of the first aspect, the toggle switch includes a double pole double throw switch, and the at least two output ports include a first output port and a second output port; and two ports of the double pole double throw switch are respectively electrically connected to the first power supply and the second power supply, and other two ports of the double pole double throw switch are respectively electrically connected to the first output port and the second output port.

In the implementations, the double pole double throw switch is used for the toggle switch, so that at least four power paths may be switched from the at least two power supplies, and the low noise amplifier may obtain more performance modes with different linearity and power consumption.

With reference to the first aspect, in some implementations of the first aspect, two switch paths connected to the double pole double throw switch and the first power supply are respectively connected to m switch devices in parallel, two switch paths connected to the double pole double throw switch and the second power supply are respectively connected to n switch devices in parallel, and m≥n.

In the implementations, the two switch paths connected to the double pole double throw switch and the first power supply are respectively connected to the m switch devices in parallel, so that a conduction loss of the toggle switch may be reduced. The two switch paths connected to the double pole double throw switch and the second power supply are respectively connected to the n switch devices in parallel, so that a conduction loss of the toggle switch may be reduced. In addition, because the voltage value of the first power supply is greater than the voltage value of the second power supply, m may be set to be greater than or equal to n, to adapt to conduction losses of voltage values of different power supplies.

Optionally, the switch device may be a metal oxide semiconductor field effect transistor (metal oxide semiconductor field effect transistor, MOSFET).

According to a second aspect, a low noise amplifier is provided, including the power supply and load switching circuit.

In the embodiments of this application, at least four performance modes with different linearity and power consumption may be obtained by switching different power paths of the at least two power supplies in the power supply and load switching circuit, and at least two performance modes with different operating bands may be obtained by switching different impedance values of the at least two loads, to enable the low noise amplifier to obtain more different performance modes.

With reference to the second aspect, in some implementations of the second aspect, the low noise amplifier further includes a low noise amplification module; and the low noise amplification module is electrically connected to the power supply and load switching circuit, to perform low noise amplification on an input signal.

In the embodiments of this application, the power supply and load switching circuit provides the low noise amplification module with power supplies of different voltage values and loads of different impedance values. The low noise amplification module performs low noise amplification on an input signal, to enable the low noise amplifier to obtain more different performance modes.

With reference to the second aspect, in some implementations of the second aspect, the low noise amplification module includes a first amplifier, a second amplifier, a bias circuit, and a controller; the power supply and load switching circuit is electrically connected to the first amplifier, the second amplifier, and the controller separately, and both the first amplifier and the second amplifier are electrically connected to the bias circuit; the first amplifier is configured to amplify a first input signal; the second amplifier is configured to amplify a second input signal; the bias circuit is configured to provide a bias voltage to the first amplifier and the second amplifier; and the controller is configured to provide a mode switch signal to the power supply and load switch module.

In the embodiments of this application, the first amplifier and the second amplifier are respectively electrically connected to the at least two output ports in the power supply and load switching circuit, so that the first amplifier and the second amplifier may respectively obtain performance modes with different linearity, power consumption, and operating bands, to enable the low noise amplifier to obtain more different performance modes.

With reference to the second aspect, in some implementations of the second aspect, the first amplifier includes a first transistor, a second transistor, a first input inductor, a first source inductor, a first input port, and a first output port; the bias circuit outputs a first bias voltage and a second bias voltage; and a gate of the first transistor is connected to the first input port through the first input inductor, a source of the first transistor is grounded through the first source inductor, a drain of the first transistor is electrically connected to a source of the second transistor, a drain of the second transistor is electrically connected to the first output port, the first bias voltage is applied to the gate of the first transistor, and the second bias voltage is applied to a gate of the second transistor.

In the embodiments of this application, a cascode amplifier is formed through the first transistor and the second transistor, for performing amplification on the first input signal. Impedance matching is performed on the first input signal through the first input inductor, a gain of the first amplifier is adjusted through the first source inductor, and the power supply and load switching circuit with a plurality of performance modes is combined, to enable the low noise amplifier to obtain more different performance modes.

With reference to the second aspect, in some implementations of the second aspect, the first amplifier further includes a first bias network and a second bias network; and the first bias network is connected between the gate of the first transistor and the first bias voltage, and the second bias network is connected between the second transistor and the second bias voltage.

In the implementations, a current impact of the first bias voltage on the first transistor is isolated through the first bias network, and a current impact of the second bias voltage on the second transistor is isolated through the second bias network.

With reference to the second aspect, in some implementations of the second aspect, the first amplifier further includes a first input capacitor, a first gate bias capacitor, and a first output capacitor; and the first input capacitor is connected between the gate of the first transistor and the first input inductor, the first gate bias capacitor is connected between the gate of the second transistor and a ground end, and the first output capacitor is connected between the drain of the second transistor and the first output port.

In the implementations, impedance matching is performed on the first input signal through cooperation of the first output capacitor and the first input inductor, a bias voltage of the second transistor is filtered through the first gate bias capacitor, and an output signal is filtered through the first output capacitor.

With reference to the second aspect, in some implementations of the second aspect, the first amplifier further includes a fifth switch and a sixth switch; and the fifth switch is connected between the gate of the second transistor and a ground end, the sixth switch is connected between the gate of the second transistor and the second bias voltage, and the fifth switch and the sixth switch are separately electrically connected to the controller.

In the implementations, conduction and cutoff between the second transistor and the ground end are controlled through the fifth switch, and conduction and cutoff between the second transistor and the bias circuit are controlled through the sixth switch.

With reference to the second aspect, in some implementations of the second aspect, the first amplifier further includes a first auxiliary path; and two ends of the first auxiliary path are respectively electrically connected to the source of the second transistor and the gate of the second transistor, and the first auxiliary path is further electrically connected to the controller.

In the implementations, when the second transistor operates as a switch device, the second transistor may be directly bypassed through the first auxiliary path, thereby reducing conduction power consumption of the path caused by the second transistor.

With reference to the second aspect, in some implementations of the second aspect, the second amplifier includes a third transistor, a fourth transistor, a second input inductor, a second source inductor, a second input port, and a second output port; the bias circuit outputs a third bias voltage and a fourth bias voltage; and a gate of the third transistor is connected to the second input port through the second input inductor, a source of the third transistor is grounded through the second source inductor, a drain of the third transistor is electrically connected to a source of the fourth transistor, a drain of the fourth transistor is electrically connected to the second output port, the third bias voltage is applied to the gate of the third transistor, and the fourth bias voltage is applied to a gate of the fourth transistor.

In the embodiments of this application, a cascode amplifier is formed through the third transistor and the fourth transistor, for performing amplification on the second input signal. Impedance matching is performed on the second input signal through the second input inductor, a gain of the second amplifier is adjusted through the second source inductor, and the power supply and load switching circuit with a plurality of performance modes is combined, to enable the low noise amplifier to obtain more different performance modes.

With reference to the second aspect, in some implementations of the second aspect, the second amplifier further includes a third bias network and a fourth bias network; and the third bias network is connected between the gate of the third transistor and the third bias voltage, and the fourth bias network is connected between the fourth transistor and the fourth bias voltage.

In the implementations, a current impact of the third bias voltage on the third transistor is isolated through the third bias network, and a current impact of the fourth bias voltage on the fourth transistor is isolated through the fourth bias network.

With reference to the second aspect, in some implementations of the second aspect, the second amplifier further includes a second input capacitor, a second gate bias capacitor, and a second output capacitor; and the second input capacitor is connected between the gate of the third transistor and the second input inductor, the second gate bias capacitor is connected between the gate of the fourth transistor and the ground end, and the second output capacitor is connected between the drain of the fourth transistor and the second output port.

In the implementations, impedance matching is performed on the second input signal through cooperation of the second output capacitor and the second input inductor, a bias voltage of the fourth transistor is filtered through the second gate bias capacitor, and an output signal is filtered through the second output capacitor.

With reference to the second aspect, in some implementations of the second aspect, the second amplifier further includes a seventh switch and an eighth switch; and the seventh switch is connected between the gate of the fourth transistor and the ground end, the eighth switch is connected between the gate of the fourth transistor and the fourth bias voltage, and the seventh switch and the eighth switch are separately electrically connected to the controller.

In the implementations, conduction and cutoff between the fourth transistor and the ground end are controlled through the seventh switch, and conduction and cutoff between the fourth transistor and the bias circuit are controlled through the eighth switch.

With reference to the second aspect, in some implementations of the second aspect, the second amplifier further includes a second auxiliary path; and two ends of the second auxiliary path are respectively electrically connected to the source of the fourth transistor and the gate of the fourth transistor, and the second auxiliary path is further electrically connected to the controller.

In the embodiments of this application, when the fourth transistor operates as a switch device, the fourth transistor may be directly bypassed through the second auxiliary path, thereby reducing conduction power consumption of the path caused by the fourth transistor.

With reference to the second aspect, in some implementations of the second aspect, the low noise amplifier further includes a first carrier board and a first chip; and the low noise amplification module and the power supply and load switching circuit are jointly integrated on the first chip, and the first chip is arranged on the first carrier board.

In the embodiments of this application, the low noise amplification module and the power supply and load switching circuit are jointly integrated on the same chip, so that an area of the low noise amplifier may be reduced, and assembly with another device is facilitated.

With reference to the second aspect, in some implementations of the second aspect, the low noise amplifier further includes a second carrier board, a second chip, and a third chip; and the low noise amplification module and the power supply and load switching circuit are respectively integrated on the second chip and the third chip, and the second chip and the third chip are arranged on the second carrier board.

In the embodiments of this application, the low noise amplification module and the power supply and load switching circuit are respectively integrated on different chips, so that modification or replacement of the low noise amplification module and the power supply and load switching circuit may be facilitated.

With reference to the second aspect, in some implementations of the second aspect, the low noise amplifier further includes a third carrier board, a fourth chip, and a fifth chip; and the low noise amplification module and the power supply and load switching circuit are respectively integrated on the fourth chip and the fifth chip, and the fourth chip and the fifth chip are stacked on the third carrier board.

In the embodiments of this application, the low noise amplification module and the power supply and load switching circuit are stacked and jointly integrated on the same carrier board, so that a volume of the low noise amplifier may be reduced.

With reference to the second aspect, in some implementations of the second aspect, the low noise amplifier further includes a fourth carrier board, a fifth carrier board, a sixth chip, and a seventh chip; and the low noise amplification module and the power supply and load switching circuit are respectively integrated on the sixth chip and the seventh chip, the sixth chip is arranged on the fourth carrier board, the seventh chip is arranged on the fifth carrier board, and the fourth carrier board and the fifth carrier board are stacked.

In the implementations, the low noise amplification module and the power supply and load switching circuit are respectively stacked on different carrier boards, so that modification or replacement of the low noise amplification module and the power supply and load switching circuit may be facilitated.

According to a third aspect, a radio frequency front end module is provided, including a low noise amplifier.

According to a fourth aspect, a radio frequency front end chip is provided, including the foregoing radio frequency front end module.

According to a fifth aspect, an electronic device is provided, including the described low noise amplifier.

In the embodiments of this application, the electronic device receives a downlink signal through the low noise amplifier, and performs low noise amplification on the downlink signal, to obtain a received signal with a high signal-to-noise ratio.

### BRIEF DESCRIPTION OF DRAWINGS

FIG. 1 is a schematic diagram of a scenario of a mobile communication system to which an embodiment of this application is applied;
FIG. 2 is a schematic structural diagram of an electronic device according to an embodiment of this application;
FIG. 3 is a schematic structural diagram of a radio frequency front end module according to an embodiment of this application;
FIG. 4 is a circuit diagram of a low noise amplifier according to an embodiment of this application;
FIG. 5 is a diagram of an operating mode of a low noise amplifier according to an embodiment of this application;
FIG. 6 is another diagram of an operating mode of a low noise amplifier according to an embodiment of this application;
FIG. 7 is a circuit diagram of a power supply and load switching circuit according to an embodiment of this application;
FIG. 8 is another circuit diagram of a power supply and load switching circuit according to an embodiment of this application;
FIG. 9 is another circuit diagram of a power supply and load switching circuit according to an embodiment of this application;
FIG. 10 is another circuit diagram of a power supply and load switching circuit according to an embodiment of this application;
FIG. 11 is another circuit diagram of a power supply and load switching circuit according to an embodiment of this application;
FIG. 12 is another circuit diagram of a power supply and load switching circuit according to an embodiment of this application;
FIG. 13 is a circuit diagram of a toggle switch according to an embodiment of this application;
FIG. 14 is a schematic structural diagram of a low noise amplifier according to an embodiment of this application;
FIG. 15 is another circuit diagram of a low noise amplifier according to an embodiment of this application;
FIG. 16 is another diagram of an operating mode of a low noise amplifier according to an embodiment of this application;
FIG. 17 is another diagram of an operating mode of a low noise amplifier according to an embodiment of this application;
FIG. 18 is another circuit diagram of a low noise amplifier according to an embodiment of this application;
FIG. 19 is another circuit diagram of a low noise amplifier according to an embodiment of this application;
FIG. 20 is a structural packaging diagram of a low noise amplifier according to an embodiment of this application;
FIG. 21 is another structural packaging diagram of a low noise amplifier according to an embodiment of this application;
FIG. 22 is another structural packaging diagram of a low noise amplifier according to an embodiment of this application; and
FIG. 23 is another structural packaging diagram of a low noise amplifier according to an embodiment of this application.

### DESCRIPTION OF EMBODIMENTS

The following clearly and thoroughly describes technical solutions in embodiments of this application with reference to the accompanying drawings. In the descriptions of the embodiments of this application, "/" means "or" unless otherwise specified. For example, A/B may represent A or B. The term "and/or" in the text describes only an association relationship for describing associated objects and represents that three relationships may exist. For example, A and/or B may represent the following three cases: Only A exists, both A and B exist, and only B exists.

The terms "first", "second", and the like are used for descriptive purposes only and should not be construed as implying or implying relative importance or implicitly indicating the number of technical features indicated. Therefore, a feature defined to be "first" or "second" may explicitly or implicitly include one or more features. In the description of the embodiments of this application, unless otherwise stated, "A plurality of" refers to two or more.

For ease of understanding of the embodiments of this application, related concepts involved in the embodiments of this application are first briefly described below.

### 1. Radio frequency front end (radio frequency front end, RFFE)

In the field of communication, the radio frequency front end refers to a series of components between a radio frequency transceiver and an antenna, and mainly includes a power amplifier (PA), an antenna switch (Switch), a filter (Filter), a duplexer (Duplexer and Diplexer), and a low noise amplifier (LNA), which directly affects signal transmitting and receiving of an electronic device.

### 2. Low noise amplifier (low noise amplifier, LNA)

In the field of communication, the low noise amplifier refers to an amplifier with a very low noise figure, which is used as a high-frequency or intermediate-frequency preamplifier for various radio receivers and an amplification circuit for a high-sensitivity electronic detection device. In a scenario of amplifying a weak signal, a noise of the amplifier may seriously interfere with the signal. In this case, it is expected to reduce the noise to improve an output signal-to-noise ratio.

### 3. Transmit (transmit, TX)

In the field of communication, transmitting refers to a behavior of sending data from a device to another device or a group of devices.

### 4. Receive (receive, RX)

In the field of communication, receiving refers to a process of converting a transmitted signal into perceivable information.

### 5. Uplink signal

In the field of communication, the uplink signal refers to an uplink beam sent by an electronic device and received by a base station.

### 6. Downlink signal

In the field of communication, the downlink signal refers to a downlink beam sent by a base station and received by an electronic device.

### 7. Linearity

In the field of communication, the linearity is also referred to as a nonlinear error, and refers to a degree of closeness and deviation between an actual input/output characteristic curve and an ideal input/output characteristic curve (referred to as a fitted straight line).

### 8. Mutual inductance

In the field of circuits, the mutual inductance refers to a measure of induction between two circuits or induction between parts of the two circuits. When a current in a coil changes, an induced electromotive force is generated in another nearby coil, which is referred to as a mutual inductance phenomenon. The mutual inductance phenomenon is a common electromagnetic inductance phenomenon that may occur not only between two coils wound on a same iron core, but also between any two circuits close to each other.

### 9. Impedance matching

In the field of communication, the impedance matching refers to a suitable matching manner between a signal source or transmission line and a load. An internal resistance of the signal source is equal in magnitude and phase to a characteristic impedance of a connected transmission line, or a characteristic impedance of the transmission line is equal in magnitude and phase to an impedance of a connected load. This is referred to as an input or output end of the transmission line being in an impedance matching state, which is referred to as the impedance matching for short. Otherwise, it is referred to as impedance mismatching.

### 10. Gain (gain)

In the field of communication, the gain generally refers to a ratio of a signal output of a system to a signal input. For example, an antenna gain represents a parameter of a concentration degree of directional antenna radiation, and is a ratio of squares of electric field strengths generated by a directional antenna and a nondirectional antenna in a predetermined direction. An amplifier gain represents an amplifier power amplification factor, which is expressed as a common logarithm of a ratio of output power to input power.

The above is a brief introduction to nouns involved in the embodiments of this application, and details are not described again below.

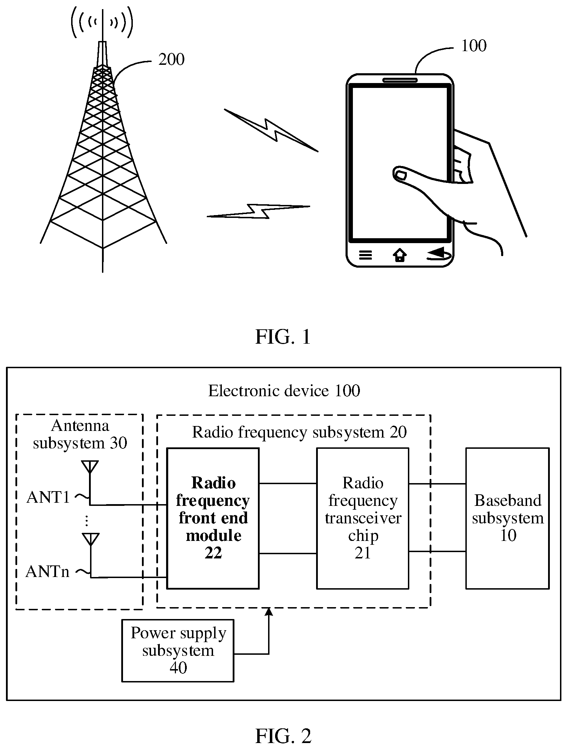

FIG. 1 is a schematic diagram of a scenario of a mobile communication system to which an embodiment of this application is applied.

As shown in FIG. 1, a user may communicate with a base station 200 by using an electronic device 100. A type of the electronic device 100 is not specifically limited in this embodiment of this application. In some embodiments, the electronic device 100 may be a mobile phone, a wearable device (for example, a smart band, a smartwatch, or a headset), a tablet computer, a laptop computer (laptop), a handheld computer, a notebook computer, an ultra-mobile personal computer (ultra-mobile personal computer, UMPC), a cellular phone, a personal digital assistant (personal digital assistant, PDA), or an IOT (internet of things, IOT) device such as an augmented reality (augmented reality, AR)\virtual reality (virtual reality, VR) device, or may be a device such as a television, a big screen, a printer, or a projector. For ease of understanding, the following embodiments are exemplarily described with an example in which the electronic device 100 is a mobile phone.

FIG. 2 is a schematic structural diagram of an electronic device according to an embodiment of this application.

As shown in FIG. 2, the electronic device 100 may include a baseband subsystem 10, a radio frequency subsystem 20 including a radio frequency transceiver chip (radio frequency integrated circuit, RFIC) 21 and a radio frequency front end (radio frequency front end, RFFE) module 22, an antenna (antenna, ANT) subsystem 30, a power subsystem 40, and the like. These devices may be coupled through various interconnection buses or in other electrical connection manners.

The baseband subsystem 10 may extract useful information or a data bit from a baseband signal, or convert information or a data bit into a to-be-sent baseband signal. The information or data bit may be data representing user data such as audio, a text, and a video, or control information. Exemplarily, the baseband subsystem 10 may implement signal processing operations such as modulation and demodulation, and encoding and decoding. Different baseband signal processing operations may be provided for different radio access technologies, such as 5G NR and 4G LTE. Therefore, to support a plurality of mobile communication modes, the baseband subsystem 10 may also include a plurality of processing cores or a plurality of hardware accelerators (hardware accelerator, HAC). The baseband subsystem 10 may be integrated into one or more chips.

Exemplarily, the baseband subsystem 10 may be used as an independent chip, and the chip may be referred to as a modem (modem) chip. A hardware component of the baseband subsystem 10 may be manufactured and sold in a unit of the modem chip. The modem chip may alternatively be referred to as a baseband chip or a baseband processor. In addition, alternatively, the baseband subsystem 10 may be further integrated into a system on chip (system on chip technology, SOC) chip, and is manufactured and sold in a unit of the SOC chip. A software component of the baseband subsystem 10 may be built into a hardware component of a chip before the chip is delivered from a factory, or may be imported from another non-volatile memory into a hardware component of a chip after the chip is delivered from a factory, or software components may be downloaded and updated online through a network.

In addition, because a radio frequency signal is an analog signal, a signal processed by the baseband subsystem 10 is mainly a digital signal, and an analog-to-digital conversion device is further required in the electronic device. The analog-to-digital conversion device may include an analog to digital converter (analog to digital converter, ADC) converting an analog signal into a digital signal, and a digital to analog converter (digital to analog converter, DAC) converting a digital signal into an analog signal. It should be understood that, the analog-to-digital conversion device and the digital to analog converter may be arranged in the baseband subsystem 10, or may be arranged in the radio frequency subsystem 20. This is not limited in the embodiments of this application.

The radio frequency subsystem 20 may be divided into a radio frequency receive path (RF receive path) and a radio frequency transmit path (TF transmit path). The radio frequency receive path may receive a radio frequency signal through an antenna, perform processing such as amplification, filtering, down-conversion, and analog-to-digital conversion on the radio frequency signal to obtain a baseband signal, and transmit the baseband signal to the baseband subsystem 10. The radio frequency transmit path may receive a baseband signal from the baseband subsystem 10, perform processing such as up-conversion, amplification, filtering, and digital-to-analog conversion on the baseband signal to obtain a radio frequency signal, and radiate the radio frequency signal to space through an antenna. Specifically, the radio frequency subsystem 20 may include electronic components such as a radio frequency switch, a duplexer, an antenna tuner, a low noise amplifier (low noise amplifier, LNA), a power amplifier, a mixer (mixer), a local oscillator (local oscillator, LO), and a filter. The electronic components may be integrated into one or more chips based on requirements. Sometimes, the antenna may alternatively be considered as a part of the radio frequency subsystem 20.

Exemplarily, the foregoing electronic components may be separately arranged in the antenna, the radio frequency front end module 22, and the radio frequency transceiver chip 21. The radio frequency transceiver chip 21 may be formed by devices such as the mixer and the local oscillator. The local oscillator is configured to provide a local oscillator signal; and the mixer is configured to perform frequency mixing on the radio frequency signal and the local oscillator signal provided by the local oscillator. The radio frequency transceiver chip 21 may alternatively be referred to as a receiver, a transmitter, a transceiver, or the like.

The radio frequency front end module 22 may be formed by electronic components such as the filter, the low noise amplifier, the power amplifier, and the radio frequency switch. The radio frequency switch is configured to switch between receiving and transmitting the radio frequency signal and switch between different bands. The duplexer is configured to isolate a transmit path and a receive path of the radio frequency signal, to ensure that reception and transmission can be normally performed when sharing the same antenna. The filter is configured to retain a signal within a specific band and filter out a signal outside a characteristic band. The low noise amplifier is configured to amplify the radio frequency signal of the receive path. The power amplifier is configured to amplify the radio frequency signal of the transmit path.

In this embodiment of this application, the low noise amplifier may include a power supply and load switching circuit.

The radio frequency transceiver chip 21 herein may output a control signal to a component such as the radio frequency switch in the radio frequency front end module 22 through a control line, to control the radio frequency switch to switch between different links.

It should be understood that, the foregoing is merely an example, and the radio frequency subsystem 20 may alternatively include another device or use another integrated manner. For example, a part of devices of the radio frequency front end module 22 may be integrated into the radio frequency transceiver chip 21, or both the antenna and the radio frequency front end module 22 are integrated into the radio frequency transceiver chip 21. For details, settings and modifications may be performed based on requirements. This is not limited in the embodiments of this application.

An antenna subsystem 30 includes a plurality of antennas. ANT1 represents a first antenna, and ANTn represents an n^{th} antenna, where n is a positive integer greater than 1. The antenna subsystem 30 may also include an antenna switch configured to switch to a different antenna, so that different signals are transmitted by using different antennas.

A power supply subsystem 40 is configured to supply power to each device. For example, the power supply may provide a voltage for the power amplifier. The power supply subsystem 40 may include a plurality of power supplies. The plurality of power supplies may be the same or different. The power supply subsystem 40 may further supply power to the baseband subsystem 10, the radio frequency subsystem 20, and the antenna subsystem 30. Power may be supplied to the subsystems by using the same power supply or using different power supplies.

In addition, the electronic device 100 may further include an application subsystem. The application subsystem may be used as a main control system or a main computing system of the electronic device 100 for running a main operating system and an application and managing software and hardware resources of the entire electronic device 100, and may provide a user operation interface for the user. The application subsystem may include one or more processing cores. In addition, the application subsystem may also include drive software related to another subsystem (for example, the baseband subsystem 10). The baseband subsystem 10 may also include one or more processing cores, a hardware accelerator, a cache, and the like.

It should be understood that, the foregoing is merely an example for a structure of the electronic device 100, and the electronic device 100 may alternatively include another subsystem or device. For details, settings and modifications may be performed based on requirements. This is not limited in the embodiments of this application.

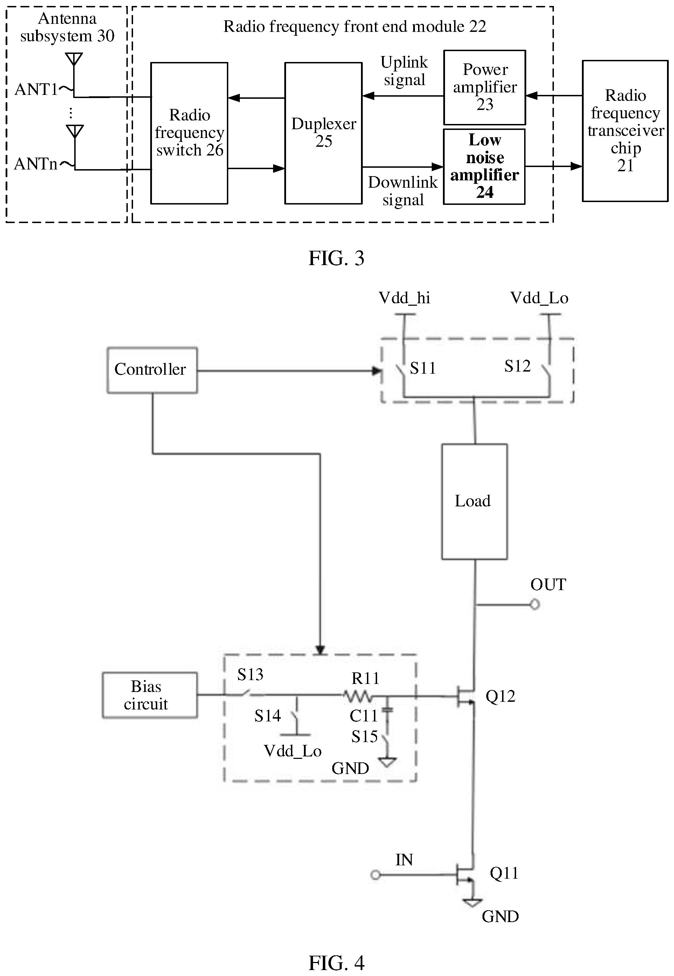

FIG. 3 is a schematic structural diagram of a radio frequency front end module according to an embodiment of this application.

As shown in FIG. 3, a radio frequency front end module 22 may include a power amplifier 23, a low noise amplifier 24, a duplexer 25, and a radio frequency switch 26. An input end of the power amplifier 23 is electrically connected to an output end of a radio frequency transceiver chip 21. An output end of the power amplifier 23 is electrically connected to the radio frequency switch 26 through the duplexer 25. The radio frequency switch 26 is further electrically connected to an input end of the low noise amplifier 24 through the duplexer 25. An output end of the low noise amplifier 24 is electrically connected to the radio frequency transceiver chip 21. An uplink signal flows through the power amplifier 23, and a downlink signal flows through the low noise amplifier 24.

The power amplifier 23 is configured to perform power amplification on a radio frequency signal of a transmit path, the low noise amplifier 24 is configured to perform low noise amplification on a radio frequency signal of a receive path, and the duplexer 25 is configured to isolate the transmit path and the receive path of the radio frequency signal, to ensure that reception and transmission can be normally performed when sharing the same antenna. The radio frequency switch 26 is configured to switch between receiving and transmitting the radio frequency signal and switch between different bands.

Currently, in a process in which the low noise amplifier in the radio frequency front end module 22 receives the downlink signal from a complex environment, there are different performance requirements for different application scenarios. For example, in a satellite communication application scenario, there is a high requirement on linearity and noise; and in a cellular communication application scenario, there is a high requirement on noise and power consumption. For an existing low noise amplifier, linearity and power consumption of the low noise amplifier are adjusted generally by using two power supplies, and there are few adjustable performance modes, which cannot meet requirements of more application scenarios of the low noise amplifier.

In view of this, the embodiments of this application provide a power supply and load switching circuit, at least four performance modes with different linearity and power consumption may be obtained by switching different power paths of at least two power supplies, and at least two performance modes with different operating bands may be obtained by switching different impedance values of at least two loads, to enable the low noise amplifier to obtain more different performance modes.

With reference to FIG. 4 to FIG. 6, the following first describes in detail a problem that only two power supplies can be used in the low noise amplifier to adjust the linearity and power consumption of the low noise amplifier.

FIG. 4 is a circuit diagram of a low noise amplifier according to an embodiment of this application.

As shown in FIG. 4, in an embodiment provided in this application, the low noise amplifier includes a controller, a high-voltage power supply Vdd_hi, a low-voltage power supply Vdd_Lo, an eleventh switch S11, a twelfth switch S12, a load, an eleventh transistor Q11, a twelfth transistor Q12, a bias circuit, a thirteenth switch S13, a fourteenth switch S14, a fifteenth switch S15, an eleventh resistor R11, and an eleventh capacitor C11. The high-voltage power supply Vdd_hi is electrically connected to the load through the eleventh switch S11. The low-voltage power supply Vdd_Lo is electrically connected to the load through the twelfth switch S12. A gate of the eleventh transistor Q11 is electrically connected to an input end. A source of the eleventh transistor Q11 is grounded. A drain of the eleventh transistor Q11 is electrically connected to a source of the twelfth transistor Q12. A drain of the twelfth transistor is electrically connected to the load and the output end. A gate of the twelfth transistor Q12 is electrically connected to the bias circuit through the eleventh resistor R11 and the thirteenth switch S13 sequentially. The gate of the twelfth transistor Q12 is further grounded through the eleventh capacitor C11 and the fifteenth switch S15 sequentially. A common connection end of the eleventh resistor R11 and the thirteenth switch S13 is electrically connected to the low-voltage power supply Vdd_Lo through the fourteenth switch S14. In addition, the controller is electrically connected to the eleventh switch S11, the twelfth switch S12, the thirteenth switch S13, the fourteenth switch S14, and the fifteenth switch S15 separately.

In this embodiment of this application, the eleventh transistor Q11 and the twelfth transistor Q12 form a cascode structure for amplifying an input signal. The eleventh resistor R11 and the eleventh capacitor C11 form an impedance structure, for performing impedance matching on the input signal and cooperating with the cascode structure to achieve a low-noise amplification effect. The controller controls whether the bias circuit is connected to the twelfth transistor Q12 by turning on and off the thirteenth switch S13, to cause the twelfth transistor Q12 to operate in an amplification mode or a switch mode. The controller controls whether the low-voltage power supply Vdd_Lo is connected to the twelfth transistor Q12 by turning on and off the fourteenth switch S14, and controls whether the twelfth transistor Q12 is grounded by turning on and off the fifteenth switch S15. The controller controls whether the high-voltage power supply Vdd_hi is connected to the load by turning on and off the eleventh switch S11, and controls whether the low-voltage power supply Vdd_Lo is connected to the load by turning on and off the twelfth switch S12. As a result, the low noise amplifier can switch only between two power supplies. In addition, an operating band cannot be adjusted because an impedance value of the load is unchanged.

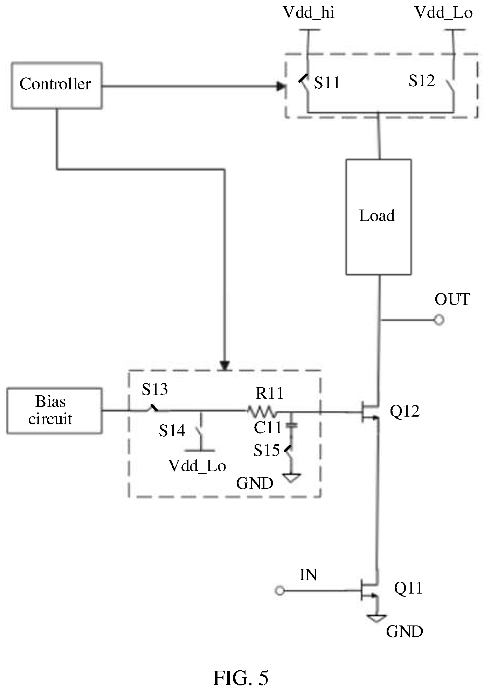

FIG. 5 is a diagram of an operating mode of a low noise amplifier according to an embodiment of this application.

As shown in FIG. 5, in an embodiment provided in this application, a controller controls an eleventh switch S11 to be turned on, a twelfth switch S12 to be turned off, a thirteenth switch S13 to be turned on, a fourteenth switch S14 to be turned off, and a fifteenth switch S15 to be turned on, to cause a high-voltage power supply Vdd_hi to supply power to a load, cause a bias circuit to provide a bias voltage for a twelfth transistor Q12, and cause the low noise amplifier to be in an amplification mode with high linearity.

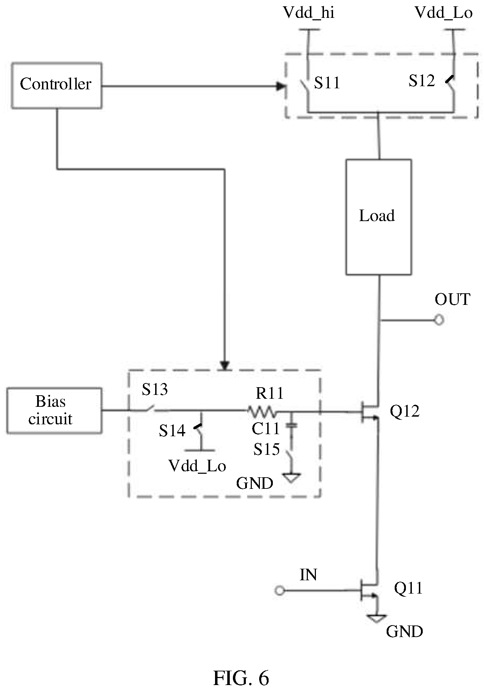

FIG. 6 is another diagram of an operating mode of a low noise amplifier according to an embodiment of this application.

As shown in FIG. 6, in an embodiment provided in this application, a controller controls an eleventh switch S11 to be turned off, a twelfth switch S12 to be turned on, a thirteenth switch S13 to be turned off, a fourteenth switch S14 to be turned on, and a fifteenth switch S15 to be turned off, to cause a low-voltage power supply Vdd_Lo to supply power to a load, cause the low-voltage power supply Vdd_Lo to provide a voltage for a twelfth transistor Q12, and cause the low noise amplifier to be in a switch mode with low power consumption. In addition, when the twelfth transistor Q12 is in the switch mode, large output impedance cannot be provided for an eleventh transistor Q11. As a result, a gain of the low noise amplifier is low, and a requirement of a high gain and high linearity cannot be implemented.

Therefore, to resolve a problem that there are only two performance modes in the embodiments of this application and more application scenario requirements of the low noise amplifier cannot be satisfied, this application provides a power supply and load switching circuit. Linearity, power consumption, and an operating band of the low noise amplifier are adjusted by switching a plurality of power supplies and a plurality of loads, to enable the low noise amplifier to obtain more different performance modes.

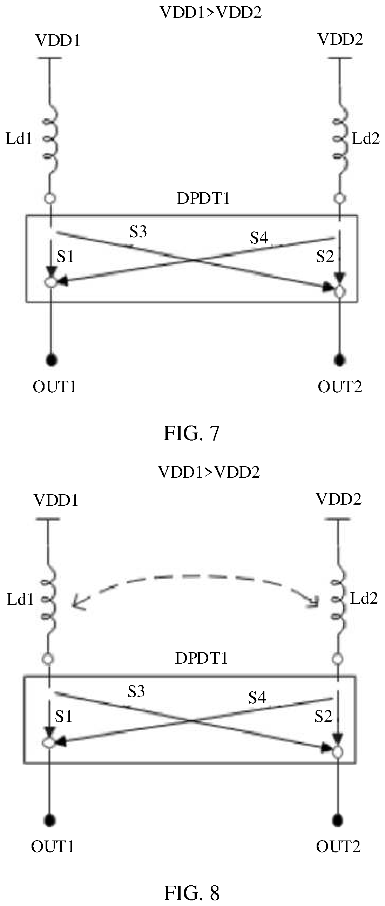

With reference to FIG. 7 to FIG. 13, the following further describes the solution for the power supply and load switching circuit of switching a plurality of power supplies and a plurality of loads in details.

FIG. 7 is a circuit diagram of a power supply and load switching circuit according to an embodiment of this application.

As shown in FIG. 7, in an embodiment provided in this application, the power supply and load switching circuit includes a first power supply VDD1, a second power supply VDD2, a first double pole double throw switch DPDT1, a first load inductor Ld1, a second load inductor Ld2, a first output port OUT1, and a second output port OUT2. Two ports of the first double pole double throw switch DPDT1 are respectively electrically connected to an end of the first load inductor Ld1 and an end of the second load inductor Ld2. The other end of the first load inductor Ld1 is connected to the first power supply VDD1. The other end of the second load inductor Ld2 is connected to the second power supply VDD2. Other two ports of the first double pole double throw switch DPDT1 are respectively electrically connected to the first output port OUT1 and the second output port OUT2. A voltage value of the first power supply VDD1 is greater than a voltage value of the second power supply VDD2.

Exemplarily, the first double pole double throw switch DPDT1 may include four switch paths: a first switch path S1, a second switch path S2, a third switch path S3, and a fourth switch path S4, which are used for connecting the first power supply VDD1/the second power supply VDD2 to the first output port OUT1/the second output port OUT2.

In this embodiment of this application, the first power supply VDD1 and the first output port OUT1 may be switched on through the first switch path S1 in the first double pole double throw switch DPDT1. When the first switch path S1 is turned on, the power supply and load switching circuit in this embodiment of this application may use the first power supply VDD1 as a voltage source for power supply, use the first load inductor Ld1 to adjust an operating band, and output a supply voltage through the first output port OUT1.

Further, the second power supply VDD2 and the second output port OUT2 may be switched on through the second switch path S2 in the first double pole double throw switch DPDT1. When the second switch path S2 is turned on, the power supply and load switching circuit in this embodiment of this application may use the second power supply VDD2 as a voltage source for power supply, use the second load inductor Ld2 to adjust an operating band, and output a supply voltage through the second output port OUT2.

Further, the first power supply VDD1 and the second output port OUT2 may be switched on through the third switch path S3 in the first double pole double throw switch DPDT1. When the third switch path S3 is turned on, the power supply and load switching circuit in this embodiment of this application may use the first power supply VDD1 as a voltage source for power supply, use the first load inductor Ld1 to adjust an operating band, and output a supply voltage through the second output port OUT2.

Further, the second power supply VDD2 and the first output port OUT1 may be switched on through the fourth switch path S4 in the first double pole double throw switch DPDT1. When the fourth switch path S4 is turned on, the power supply and load switching circuit in this embodiment of this application may use the second power supply VDD2 as a voltage source for power supply, use the second load inductor Ld2 to adjust an operating band, and output a supply voltage through the first output port OUT1.

FIG. 8 is another circuit diagram of a power supply and load switching circuit according to an embodiment of this application.

As shown in FIG. 8, in an embodiment provided in this application, the power supply and load switching circuit includes a first power supply VDD1, a second power supply VDD2, a first double pole double throw switch DPDT1, a first load inductor Ld1, a second load inductor Ld2, a first output port OUT1, and a second output port OUT2. Two ports of the first double pole double throw switch DPDT1 are respectively electrically connected to an end of the first load inductor Ld1 and an end of the second load inductor Ld2. The other end of the first load inductor Ld1 is connected to the first power supply VDD1. The other end of the second load inductor Ld2 is connected to the second power supply VDD2. Other two ports of the first double pole double throw switch DPDT1 are respectively electrically connected to the first output port OUT1 and the second output port OUT2. A voltage value of the first power supply VDD1 is greater than a voltage value of the second power supply VDD2. A coupling relationship exists between the first load inductor Ld1 and the second load inductor Ld2.

In this embodiment of this application, because the coupling relationship exists between the first load inductor Ld1 and the second load inductor Ld2, an inductance value of a power path connected to the first power supply VDD1 is a sum of an inductance value of the first load inductor Ld1 and a mutual inductance value. An inductance value of a power path connected to the second power supply VDD2 is a sum of an inductance value of the second load inductor Ld2 and the mutual inductance value, so that the power supply and load switching circuit may obtain other two load impedance values, to further enable the low noise amplifier to obtain performance modes of other two operating bands. In addition, in cooperation, the first double pole double throw switch DPDT1 switches on four power paths between the first power supply VDD1, the second power supply VDD2, the first output port OUT1, and the second output port OUT2, so that the low noise amplifier may obtain four performance modes with different linearity and power consumption. A combination of the two enables the low noise amplifier to obtain more different performance modes.

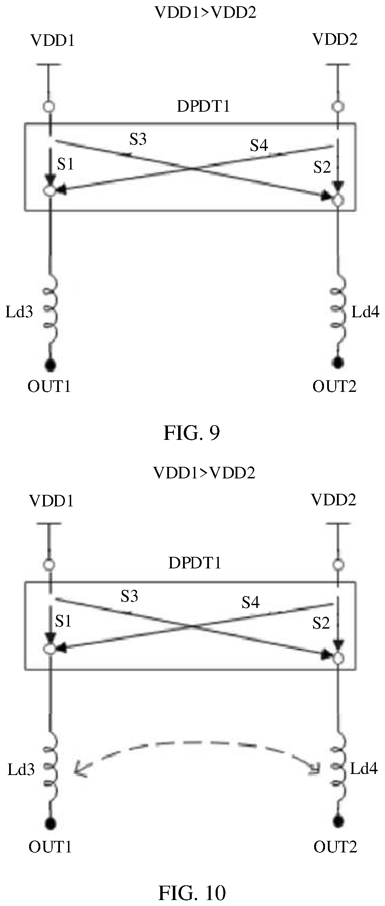

FIG. 9 is another circuit diagram of a power supply and load switching circuit according to an embodiment of this application.

As shown in FIG. 9, in an embodiment provided in this application, the power supply and load switching circuit includes a first power supply VDD1, a second power supply VDD2, a first double pole double throw switch DPDT1, a third load inductor Ld3, a fourth load inductor Ld4, a first output port OUT1, and a second output port OUT2. Two ports of the first double pole double throw switch DPDT1 are respectively connected to the first power supply VDD1 and the second power supply VDD2. Other two ports of the first double pole double throw switch DPDT1 are respectively electrically connected to an end of the third load inductor Ld3 and an end of the fourth load inductor Ld4. The other end of the third load inductor Ld1 is electrically connected to the first output port OUT1. The other end of the fourth load inductor Ld4 is electrically connected to the second output port OUT2. A voltage value of the first power supply VDD1 is greater than a voltage value of the second power supply VDD2.

In this embodiment of this application, because the third load inductor Ld3 is arranged between the first double pole double throw switch DPDT1 and the first output port OUT1, an inductance value of a power path connected to the first output port OUT1 is an inductance value of the third load inductor Ld3. Because the fourth load inductor Ld4 is arranged between the first double pole double throw switch DPDT1 and the second output port OUT2, an inductance value of a power path connected to the second output port OUT2 is an inductance value of the fourth load inductor Ld4, so that the power supply and load switching circuit may obtain other two load impedance values, to further enable the low noise amplifier to obtain performance modes of other two operating bands. In addition, in cooperation, the first double pole double throw switch DPDT1 switches on four power paths between the first power supply VDD1, the second power supply VDD2, the first output port OUT1, and the second output port OUT2, so that the low noise amplifier may obtain four performance modes with different linearity and power consumption. A combination of the two enables the low noise amplifier to obtain more different performance modes.

FIG. 10 is another circuit diagram of a power supply and load switching circuit according to an embodiment of this application.

As shown in FIG. 10, in an embodiment provided in this application, the power supply and load switching circuit includes a first power supply VDD1, a second power supply VDD2, a first double pole double throw switch DPDT1, a third load inductor Ld3, a fourth load inductor Ld4, a first output port OUT1, and a second output port OUT2. Two ports of the first double pole double throw switch DPDT1 are respectively connected to the first power supply VDD1 and the second power supply VDD2. Other two ports of the first double pole double throw switch DPDT1 are respectively electrically connected to an end of the third load inductor Ld3 and an end of the fourth load inductor Ld4. The other end of the third load inductor Ld1 is electrically connected to the first output port OUT1. The other end of the fourth load inductor Ld4 is electrically connected to the second output port OUT2. A voltage value of the first power supply VDD1 is greater than a voltage value of the second power supply VDD2. A coupling relationship exists between the third load inductor Ld3 and the fourth load inductor Ld4.

In this embodiment of this application, because the coupling relationship exists between the third load inductor Ld3 and the fourth load inductor Ld4, an inductance value of a power path connected to the first output port OUT1 is a sum of an inductance value of the third load inductor Ld3 and a mutual inductance value, and an inductance value of a power path connected to the second output port OUT2 is a sum of an inductance value of the fourth load inductor Ld4 and the mutual inductance value, so that the power supply and load switching circuit may obtain other two load impedance values, to further enable the low noise amplifier to obtain performance modes of other two operating bands. In addition, in cooperation, the first double pole double throw switch DPDT1 switches on four power paths between the first power supply VDD1, the second power supply VDD2, the first output port OUT1, and the second output port OUT2, so that the low noise amplifier may obtain four performance modes with different linearity and power consumption. A combination of the two enables the low noise amplifier to obtain more different performance modes.

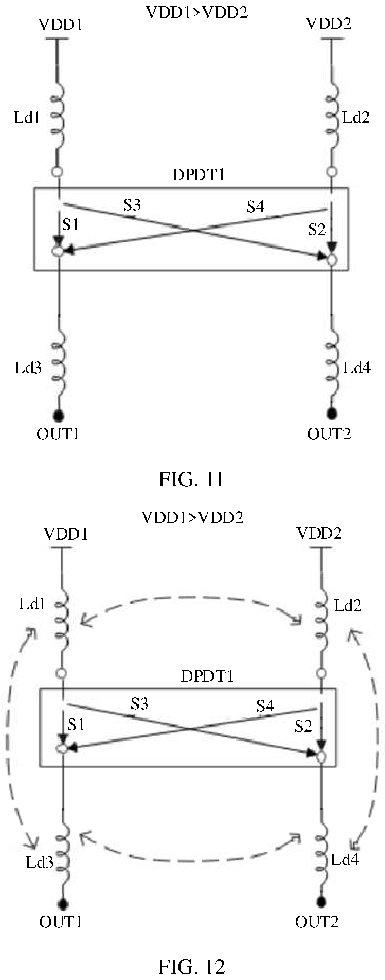

FIG. 11 is another circuit diagram of a power supply and load switching circuit according to an embodiment of this application.

As shown in FIG. 11, in an embodiment provided in this application, the power supply and load switching circuit includes a first power supply VDD1, a second power supply VDD2, a first double pole double throw switch DPDT1, a first load inductor Ld1, a second load inductor Ld2, a third load inductor Ld3, a fourth load inductor Ld4, a first output port OUT1, and a second output port OUT2. Two ports of the first double pole double throw switch DPDT1 are respectively connected to the first power supply VDD1 and the second power supply VDD2 through the first load inductor Ld1 and the second load inductor Ld2. Other two ports of the first double pole double throw switch DPDT1 are respectively electrically connected to the first output port OUT1 and the second output port OUT2 through the third load inductor Ld3 and the fourth load inductor Ld4. A voltage value of the first power supply VDD1 is greater than a voltage value of the second power supply VDD2.

In this embodiment of this application, because the first load inductor Ld1 is arranged between the first double pole double throw switch DPDT1 and the first power supply VDD1, the second load inductor Ld2 is arranged between the first double pole double throw switch DPDT1 and the second power supply VDD2, the third load inductor Ld3 is arranged between the first double pole double throw switch DPDT1 and the first output port OUT1, and the fourth load inductor Ld4 is arranged between the first double pole double throw switch DPDT1 and the second output port OUT2, an inductance value of a power path between the first power supply VDD1 and the first output port OUT1 is a sum of an inductance value of the first load inductor Ld1 and an inductance value of the third load inductor Ld3, an inductance value of a power path between the first power supply VDD1 and the second output port OUT2 is a sum of the inductance value of the first load inductor Ld1 and an inductance value of the fourth load inductor Ld4, an inductance value of a power path between the second power supply VDD2 and the second output port OUT2 is a sum of an inductance value of the second load inductor Ld2 and the inductance value of the fourth load inductor Ld4, and an inductance value of a power path between the second power supply VDD2 and the first output port OUT1 is a sum of the inductance value of the second load inductor Ld2 and the inductance value of the third load inductor Ld3, so that the power supply and load switching circuit may obtain other four load impedance values, to further enable the low noise amplifier to obtain performance modes of other four operating bands.

In addition, in cooperation, the first double pole double throw switch DPDT1 switches on four power paths between the first power supply VDD1, the second power supply VDD2, the first output port OUT1, and the second output port OUT2, so that the low noise amplifier may obtain four performance modes with different linearity and power consumption. A combination of the two enables the low noise amplifier to obtain more different performance modes.

FIG. 12 is another circuit diagram of a power supply and load switching circuit according to an embodiment of this application.

As shown in FIG. 12, in an embodiment provided in this application, the power supply and load switching circuit includes a first power supply VDD1, a second power supply VDD2, a first double pole double throw switch DPDT1, a first load inductor Ld1, a second load inductor Ld2, a third load inductor Ld3, a fourth load inductor Ld4, a first output port OUT1, and a second output port OUT2. Two ports of the first double pole double throw switch DPDT1 are respectively connected to the first power supply VDD1 and the second power supply VDD2 through the first load inductor Ld1 and the second load inductor Ld2. Other two ports of the first double pole double throw switch DPDT1 are respectively electrically connected to the first output port OUT1 and the second output port OUT2 through the third load inductor Ld3 and the fourth load inductor Ld4. A voltage value of the first power supply VDD1 is greater than a voltage value of the second power supply VDD2. A coupling relationship exists between any two of the first load inductor Ld1, the second load inductor Ld2, the third load inductor Ld3, and the fourth load inductor Ld4.

In this embodiment of this application, the first load inductor Ld1 is arranged between the first double pole double throw switch DPDT1 and the first power supply VDD1, the second load inductor Ld2 is arranged between the first double pole double throw switch DPDT1 and the second power supply VDD2, the third load inductor Ld3 is arranged between the first double pole double throw switch DPDT1 and the first output port OUT1, the fourth load inductor Ld4 is arranged between the first double pole double throw switch DPDT1 and the second output port OUT2, and the coupling relationship exists between any two of the first load inductor Ld1, the second load inductor Ld2, the third load inductor Ld3, and the fourth load inductor Ld4. Therefore, an inductance value of a power path between the first power supply VDD1 and the first output port OUT1 is a sum of an inductance value of the first load inductor Ld1, an inductance value of the third load inductor Ld3, and a mutual inductance value of the first load inductor Ld1 and the third load inductor Ld3, and an inductance value of a power path between the first power supply VDD1 and the second output port OUT2 is a sum of the inductance value of the first load inductor Ld1, an inductance value of the fourth load inductor Ld4, and a mutual inductance value of the first load inductor Ld1 and the fourth load inductor Ld4.

An inductance value of a power path between the second power supply VDD2 and the second output port OUT2 is a sum of an inductance value of the second load inductor Ld2, the inductance value of the fourth load inductor Ld4, and a mutual inductance value of the second load inductor Ld2 and the fourth load inductor Ld4, and an inductance value of a power path between the second power supply VDD2 and the first output port OUT1 is a sum of the inductance value of the second load inductor Ld2, the inductance value of the third load inductor Ld3, and a mutual inductance value between the second load inductor Ld2 and the third load inductor Ld3, so that the power supply and load switching circuit may obtain another four load impedance values, to further enable the low noise amplifier to obtain performance modes of other four operating bands. In addition, in cooperation, the first double pole double throw switch DPDT1 switches on four power paths between the first power supply VDD1, the second power supply VDD2, the first output port OUT1, and the second output port OUT2, so that the low noise amplifier may obtain four performance modes with different linearity and power consumption. A combination of the two enables the low noise amplifier to obtain more different performance modes.

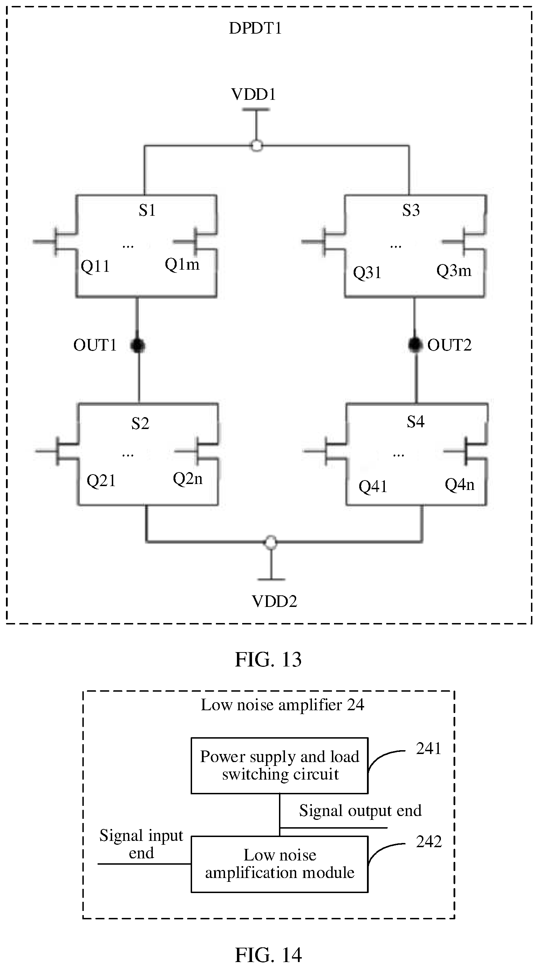

FIG. 13 is a circuit diagram of a toggle switch according to an embodiment of this application.

As shown in FIG. 13, in an embodiment provided in this application, a first double pole double throw switch DPDT1 may include four switch paths: a first switch path S1, a second switch path S2, a third switch path S3, and a fourth switch path S4. The first switch path S1 and the third switch path S3 each are electrically connected to a first power supply VDD1. The second switch path S2 and the fourth switch path S4 each are electrically connected to a second power supply VDD2. m switch devices may be connected in parallel in the first switch path S1, m switch devices may be connected in parallel in the third switch path S3, n switch devices may be connected in parallel in the second switch path S2, n switch devices may be connected in parallel in the fourth switch path S4, and m≥n.

In this embodiment of this application, the first power supply VDD1 is greater than the second power supply VDD2. When a power supply and load switching circuit uses the first power supply VDD1 as a power supply, the power supply and load switching circuit generally operates in a high-linearity application scenario, and a current flowing through in the switch device is large, so that the m switch devices may be used, to reduce a conduction loss of the toggle switch. When the power supply and load switching circuit uses the second power supply VDD2 as the power supply, the power supply and load switching circuit generally operates in a low-power consumption application scenario, and a current flowing through in the switch device is small, so that the n switch devices may be used, to reduce the conduction loss of the toggle switch. Optionally, the switch device may be a metal oxide semiconductor field effect transistor (metal oxide semiconductor field effect transistor, MOSFET).

With reference to FIG. 14 to FIG. 19, the following further describes the solution for the low noise amplifier using the power supply and load switching circuit in details.

FIG. 14 is a schematic structural diagram of a low noise amplifier according to an embodiment of this application.

As shown in FIG. 14, in an embodiment provided in this application, a low noise amplifier 24 includes a power supply and load switching circuit 241 and a low noise amplification module 242. The power supply and load switching circuit 241 is electrically connected to the low noise amplification module 242. The power supply and load switching circuit 241 is configured to provide the low noise amplification module 242 with a configuration-switchable power supply and load. The low noise amplification module 242 is configured to perform low noise amplification on an input signal.

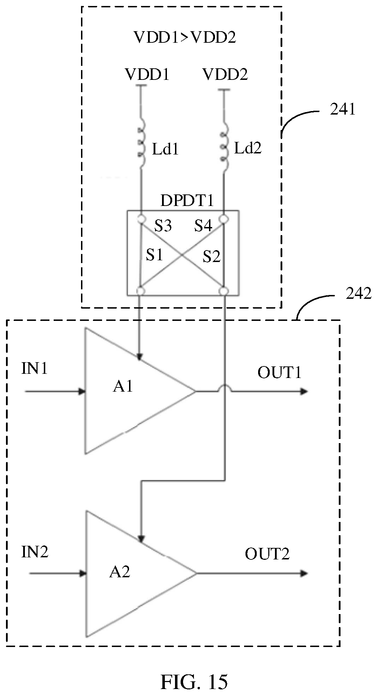

FIG. 15 is another circuit diagram of a low noise amplifier according to an embodiment of this application.

As shown in FIG. 15, in an embodiment provided in this application, the low noise amplifier includes a power supply and load switching circuit 241 and a low noise amplification module 242. The power supply and load switching circuit 241 includes a first power supply VDD1, a second power supply VDD2, a first double pole double throw switch DPDT1, a first load inductor Ld1, and a second load inductor Ld2. A port of the first double pole double throw switch DPDT1 is connected to the first power supply VDD1 through the first load inductor Ld1, and another port of the first double pole double throw switch DPDT1 is connected to the second power supply VDD2 through the second load inductor Ld2. The low noise amplification module 242 includes a first amplifier A1 and a second amplifier A2. Another port of the first double pole double throw switch DPDT1 is electrically connected to the first amplifier A1, and another port of the first double pole double throw switch DPDT1 is electrically connected to the second amplifier A2. An input port of the first amplifier A1 is connected to a first input signal IN1, and an output port of the first amplifier A1 outputs a first output signal OUT1. An input port of the second amplifier A2 is connected to a second input port IN2, and an output port of the second amplifier A2 is connected to a second output port OUT2. Exemplarily, the first double pole double throw switch DPDT1 may include a first switch path S1 and a third switch path S3 that are connected to the first power supply VDD1, and a second switch path S2 and a fourth switch path S4 that are connected to the second power supply VDD2. A voltage value of the first power supply VDD1 is greater than a voltage value of the second power supply VDD2.

In this embodiment of this application, the first double pole double throw switch DPDT1 is configured to switch on the first power supply VDD1, the first load inductor Ld1, and the first switch path S1 or the third switch path S3, and is further configured to switch on the second power supply VDD2, the second load inductor Ld2, and the second switch path S2 or the fourth switch path S4. The first amplifier A1 is configured to amplify an input signal of a first band, and the second amplifier A2 is configured to amplify an input signal of a second band. The first band and the second band may be the same or different.

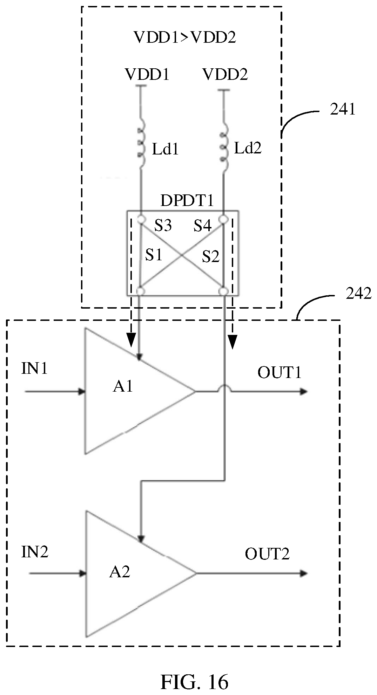

FIG. 16 is another diagram of an operating mode of a low noise amplifier according to an embodiment of this application.

As shown in FIG. 16, in an embodiment provided in this application, a power supply and load switching circuit 241 is in a direct through state, a first amplifier A1 operates in a high-linearity mode of a first band, and a second amplifier A2 operates in a low-power consumption mode of a second band. Specifically, the first double pole double throw switch DPDT1 switches on a first power supply VDD1, a first load inductor Ld1, a first switch path S1, and the first amplifier A1. The first power supply VDD1 provides power for the first amplifier A1, and the first load inductor Ld1 provides a load for the first amplifier A1, so that the first amplifier A1 may operate in the high-linearity mode of the first band. The first double pole double throw switch DPDT1 switches on a second power supply VDD2, a second load inductor Ld2, a second switch path S2, and the second amplifier A2. The second power supply VDD2 provides power for the second amplifier A2, and the second load inductor Ld2 provides a load for the second amplifier A2, so that the second amplifier A2 may operate in the low-power consumption mode of the second band.

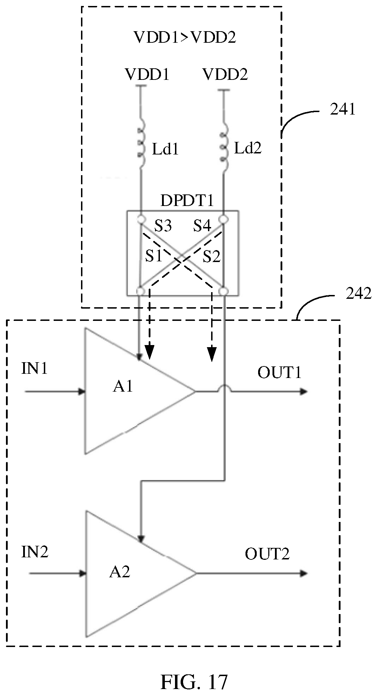

FIG. 17 is another diagram of an operating mode of a low noise amplifier according to an embodiment of this application.

As shown in FIG. 17, in an embodiment provided in this application, a power supply and load switching circuit 241 is in a crossed state, a first amplifier A1 operates in a low-power consumption mode of a first band, and a second amplifier A2 operates in a high-linearity mode of a second band. Specifically, the first double pole double throw switch DPDT1 switches on a first power supply VDD1, a first load inductor Ld1, a third switch path S3, and the second amplifier A2. The first power supply VDD1 provides power for the second amplifier A2, and the first load inductor Ld1 provides a load for the second amplifier A2, so that the second amplifier A2 may operate in the low-power consumption mode of the first band. The first double pole double throw switch DPDT1 switches on a second power supply VDD2, a second load inductor Ld2, a fourth switch path S4, and the first amplifier A1. The second power supply VDD2 provides power for the first amplifier A1, and the second load inductor Ld2 provides a load for the first amplifier A1, so that the first amplifier A1 may operate in the high-linearity mode of the second band.

Optionally, in an embodiment of this application, when the first band of the first amplifier A1 is the same as the second band of the second amplifier A2, the first amplifier A1 and the second amplifier A2 may be used as a bypass structure of a filter, satisfying a high-linearity requirement of the low noise amplifier during wireless communication.

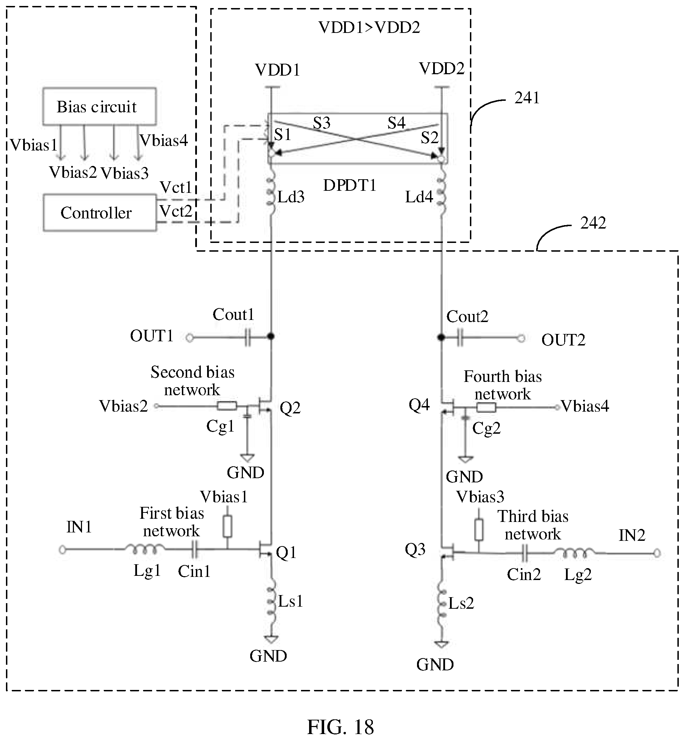

FIG. 18 is another circuit diagram of a low noise amplifier according to an embodiment of this application.

As shown in FIG. 18, in an embodiment provided in this application, the low noise amplifier includes a power supply and load switching circuit 241 and a low noise amplification module 242. The power supply and load switching circuit 241 includes a first power supply VDD1, a second power supply VDD2, a first double pole double throw switch DPDT1, a third load inductor Ld3, and a fourth load inductor Ld4. An input port of the first double pole double throw switch DPDT1 is connected to the first power supply VDD1, and another port of the first double pole double throw switch DPDT1 is connected to the second power supply VDD2. An output port of the first double pole double throw switch DPDT1 is electrically connected to the low noise amplification module 242 through the third load inductor Ld3, and another output port of the first double pole double throw switch DPDT1 is electrically connected to the low noise amplification module 242 through the fourth load inductor Ld4. Exemplarily, the first double pole double throw switch DPDT1 includes a first switch path S1 and a third switch path S3 that are connected to the first power supply VDD1, and a second switch path S2 and a fourth switch path S4 that are connected to the second power supply VDD2. A voltage value of the first power supply VDD1 is greater than a voltage value of the second power supply VDD2.

In this embodiment of this application, the first double pole double throw switch DPDT1 is configured to switch on the first power supply VDD1 and the first switch path S1 or the third switch path S3, and is further configured to switch and conduct the second power supply VDD2 and the second switch path S2 or the fourth switch path S4. The third load inductor Ld3 is used as a load between the first switch path S1, the third switch path S3, and the low noise amplification module 242, and the fourth load inductor Ld4 is used as a load between the second switch path S2, the fourth switch path S4, and the low noise amplification module 242.

As shown in FIG. 18, in an embodiment provided in this application, the low noise amplification module 242 includes a first amplifier A1, a second amplifier A2, a bias circuit, and a controller. The bias circuit is configured to output a first bias voltage Vbias1, a second bias voltage Vbias2, a third bias voltage Vbias3, and a fourth bias voltage Vbias4. The controller is configured to output a first control signal Vct1 and a second control signal Vct2. The first control signal Vct1 is used for controlling one of the first switch path S1 and the third switch path S3 of the first double pole double throw switch DPDT1 to be on. The second control signal Vct2 is used for controlling one of the second switch path S2 and the fourth switch path S4 of the first double pole double throw switch DPDT1 to be on.

The first amplifier A1 includes a first transistor Q1, a second transistor Q2, a first input inductor Lg1, a first source inductor Ls1, a first input port IN1, a first output port OUT1, a first bias network, a second bias network, a first input capacitor Cin1, a first gate bias capacitor Cg1, and a first output capacitor Cout1. A gate of the first transistor Q1 is connected to the first input port IN1 through the first input inductor Lg1, a source of the first transistor Q1 is grounded through the first source inductor Ls1, a drain of the first transistor Q1 is electrically connected to a source of the second transistor Q2, a drain of the second transistor Q2 is electrically connected to the first output port OUT1, the first bias voltage Vbias1 is applied to the gate of the first transistor Q1, and the second bias voltage Vbias2 is applied to a gate of the second transistor Q2.

The first bias network is connected between the gate of the first transistor Q1 and the first bias voltage Vbias1, and the second bias network is connected between the second transistor Q2 and the second bias voltage Vbias2. The first input capacitor Cin1 is connected between the gate of the first transistor Q1 and the first input inductor Lg1, the first bias capacitor Cg1 is connected between the gate of the second transistor Q2 and a ground end, and the first output capacitor Cout1 is connected between the drain of the second transistor Q2 and the first output port OUT1.

In this embodiment of this application, the first transistor Q1 and the second transistor Q2 form a cascode amplifier, configured to amplify a first input signal, and output an amplified signal from the first output port OUT1. The first input inductor Lg1 is used for performing impedance matching on the first input signal, the first source inductor Ls1 is used for adjusting a gain of the first amplifier A1, the first bias voltage Vbias1 is used for providing a first bias voltage for the first transistor Q1, and the second bias voltage Vbias2 is used for providing a second bias voltage for the second transistor Q2. The first bias network is used for isolating a current impact of the first bias voltage Vbias1 on the first transistor Q1, and the second bias network is used for isolating a current impact of the second bias voltage Vbias2 on the second transistor Q2. The first input capacitor Cin1 is used for forming an LC network with the first input inductor Lg1, to perform impedance matching on the first input signal, the first gate bias capacitor Cg1 is used for filtering the second bias voltage of the second transistor Q2, and the first output capacitor Cout1 is used for filtering a first output signal, to combine with the power supply and load switching circuit having a plurality of performance modes, so that the low noise amplifier may be enabled to obtain more different performance modes.

As shown in FIG. 18, in an embodiment provided in this application, the second amplifier A2 includes a third transistor Q3, a fourth transistor Q4, a second input inductor Lg2, a second source inductor Ls2, a second input port IN2, a second output port OUT2, a third bias network, a fourth bias network, a second input capacitor Cin2, a second gate bias capacitor Cg2, and a second output capacitor Cout2. A gate of the third transistor Q3 is connected to the second input port IN2 through the second input inductor Lg2, a source of the third transistor Q3 is grounded through the second source inductor Ls2, a drain of the third transistor Q3 is electrically connected to a source of the fourth transistor Q4, a drain of the fourth transistor Q4 is electrically connected to the second output port OUT2, the third bias voltage Vbias3 is applied to the gate of the third transistor Q3, and the fourth bias voltage Vbias4 is applied to a gate of the fourth transistor Q4.

The third bias network is connected between the gate of the third transistor Q3 and the third bias voltage Vbias3, and the fourth bias network is connected between the fourth transistor Q4 and the fourth bias voltage Vbias4. The second input capacitor Cin2 is connected between the gate of the third transistor Q3 and the second input inductor Lg2, the second bias capacitor Cg2 is connected between the gate of the fourth transistor Q4 and the ground end, and the second output capacitor Cout2 is connected between the drain of the fourth transistor Q4 and the second output port OUT2.

In this embodiment of this application, the third transistor Q3 and the fourth transistor Q4 form a cascode amplifier, configured to amplify a second input signal, and output an amplified signal from the second output port OUT2. The second input inductor Lg2 is used for performing impedance matching on the second input signal, the second source inductor Ls2 is used for adjusting a gain of the second amplifier A2, the third bias voltage Vbias3 is used for providing a third bias voltage for the third transistor Q3, and the fourth bias voltage Vbias4 is used for providing a fourth bias voltage for the fourth transistor Q4. The third bias network is used for isolating a current impact of the third bias voltage Vbias3 on the third transistor Q3, and the fourth bias network is used for isolating a current impact of the fourth bias voltage Vbias4 on the fourth transistor Q4. The second input capacitor Cin2 is used for forming an LC network with the second input inductor Lg2, to perform impedance matching on the second input signal, the second gate bias capacitor Cg2 is used for filtering the fourth bias voltage of the fourth transistor Q4, and the second output capacitor Cout2 is used for filtering a second output signal, to combine with the power supply and load switching circuit having a plurality of performance modes, so that the low noise amplifier may be enabled to obtain more different performance modes.

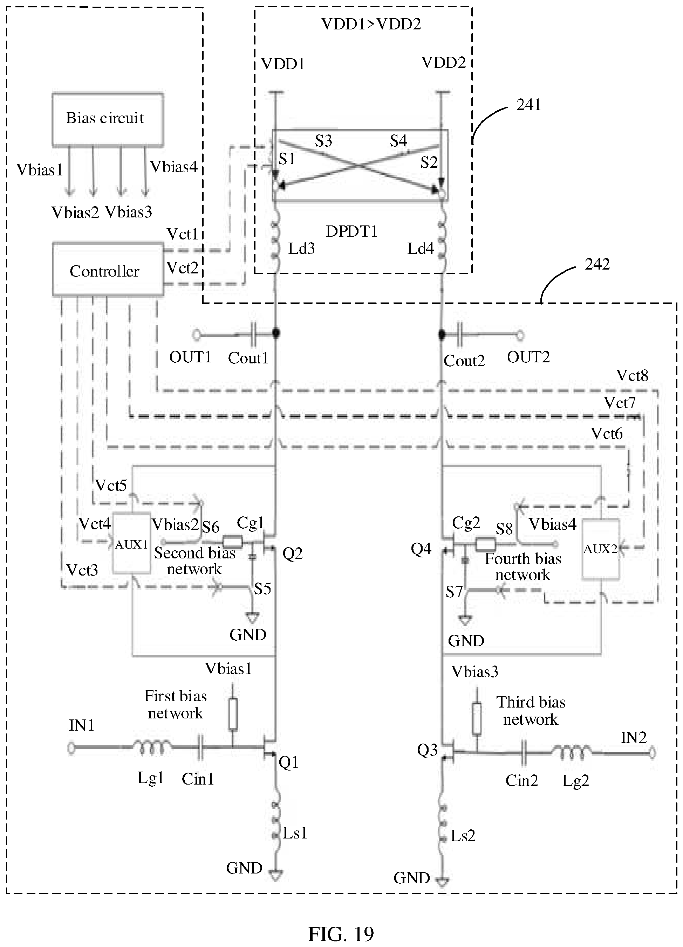

FIG. 19 is another circuit diagram of a low noise amplifier according to an embodiment of this application.

As shown in FIG. 19, in an embodiment provided in this application, the low noise amplifier includes a power supply and load switching circuit 241 and a low noise amplification module 242. A difference from a circuit of the low noise amplifier shown in FIG. 18 is that the low noise amplification module 242 includes a first amplifier A1, a second amplifier A2, a bias circuit, and a controller. The bias circuit is configured to output a first bias voltage Vbias1, a second bias voltage Vbias2, a third bias voltage Vbias3, and a fourth bias voltage Vbias4. The controller is configured to output a first control signal Vct1, a second control signal Vct2, a third control signal Vct3, a fourth control signal Vct4, a fifth control signal Vct5, a sixth control signal Vct6, a seventh control signal Vct7, and an eighth control signal Vct8. The first control signal Vct1 is used for controlling one of a first switch path S1 and a third switch path S3 of a first double pole double throw switch DPDT1 to be on. The second control signal Vct2 is used for controlling one of a second switch path S2 and a fourth switch path S4 of the first double pole double throw switch DPDT1 to be on.

The first amplifier A1 further includes a fifth switch S5, a sixth switch S6, and a first auxiliary path AUX1. The fifth switch S5 is connected between a gate of a second transistor Q2 and a ground end, and is connected to the third control signal Vct3. The sixth switch S6 is connected between the gate of the second transistor Q2 and the second bias voltage Vbias2, and is connected to the fifth control signal Vct5. Two ends of the first auxiliary path AUX1 are respectively electrically connected to a source of the second transistor Q2 and the gate of the second transistor Q2, and are connected to the fourth control signal Vct4.

Optionally, the first auxiliary path AUX1 may be formed through a switch and a matching network.

In this embodiment of this application, the third control signal Vct3 is used for controlling on and off of the fifth switch S5, to control whether the gate of the second transistor Q2 is grounded. The fourth control signal Vct4 is used for controlling on and off of the first auxiliary path AUX1, to control whether the second transistor Q2 is bypassed. The fifth control signal Vct5 is used for controlling on and off of the sixth switch S6, to control whether the second bias voltage Vbias2 is applied to the gate of the second transistor Q2.

It is to be noted that, when controlling, through the fourth control signal Vct4, the first auxiliary path AUX1 to be on and operate, the controller may function to bypass the second transistor Q2. The controller further controls, through the fifth control signal Vct5, the sixth switch S6 to be disconnected, to disconnect the second bias voltage Vbias2 of the second transistor Q2. The controller further controls, through the third control signal Vct3, the fifth switch S5 to be disconnected, so that the gate of the second transistor Q2 is disconnected from the ground end, and a drain parasitic capacitor of the first transistor Q1 is reduced, so that the first transistor Q1 is fully turned on, an on resistance is reduced, and additional conduction power consumption of the first amplifier A1 is reduced.

The second amplifier A2 further includes a seventh switch S7, an eighth switch S8, and a second auxiliary path AUX2. The seventh switch S7 is connected between a gate of a fourth transistor Q4 and the ground end, and is connected to the eighth control signal Vct8. The eighth switch S8 is connected between the gate of the fourth transistor Q4 and the fourth bias voltage Vbias4, and is connected to the sixth control signal Vct6. Two ends of the second auxiliary path AUX2 are respectively electrically connected to a source of the fourth transistor Q4 and the gate of the fourth transistor Q4, and are connected to the seventh control signal Vct7.

Optionally, the second auxiliary path AUX2 may be formed through a switch and a matching network.

In this embodiment of this application, the eighth control signal Vct8 is used for controlling on and off of the seventh switch S7, to control whether the gate of the fourth transistor Q4 is grounded. The seventh control signal Vct7 is used for controlling on and off of the second auxiliary path AUX2, to control whether the fourth transistor Q4 is bypassed. The sixth control signal Vct6 is used for controlling on and off of the eighth switch S8, to control whether the fourth bias voltage Vbias4 is applied to the gate of the fourth transistor Q4.

It is to be noted that, when controlling, through the seventh control signal Vct7, the second auxiliary path AUX2 to be on and operate, the controller may function to bypass the fourth transistor Q4. The controller further controls, through the sixth control signal Vct6, the eighth switch S8 to be disconnected, to disconnect the fourth bias voltage Vbias4 of the fourth transistor Q4. The controller further controls, through the eighth control signal Vct8, the seventh switch S7 to be disconnected, so that the gate of the fourth transistor Q4 is disconnected from the ground end, and a drain parasitic capacitor of the third transistor Q3 is reduced, so that the third transistor Q3 is fully turned on, an on resistance is reduced, and additional conduction power consumption is reduced.

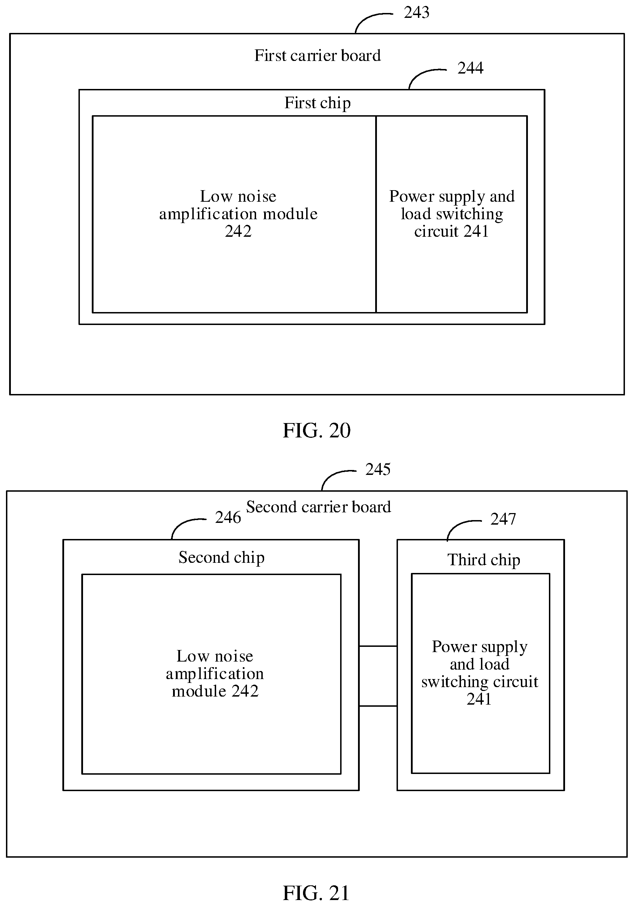

With reference to FIG. 20 to FIG. 23, the following further describes the solution for the low noise amplifier encapsulated by the power supply and load switching circuit and the low noise amplification module in details.

FIG. 20 is a structural packaging diagram of a low noise amplifier according to an embodiment of this application.

As shown in FIG. 20, in an embodiment provided in this application, the low noise amplifier includes a power supply and load switching circuit 241, a low noise amplification module 242, a first carrier board 243, and a first chip 244. The low noise amplification module 242 and the power supply and load switching circuit 241 are jointly integrated on the first chip 244, and the first chip 244 is arranged on the first carrier board 243.

In this embodiment of this application, the low noise amplification module 242 and the power supply and load switching circuit 241 may be jointly integrated on the first chip 244 by using the same semiconductor process, and the first chip 244 is arranged on the first carrier board 243, so that the low noise amplification module 242 and the power supply and load switching circuit 241 are interconnected to another electronic component through the first carrier board 243, to implement a low noise amplification function during radio frequency reception. The low noise amplification module 242 and the power supply and load switching circuit 241 are jointly integrated on the same chip, so that an area of the low noise amplifier may be reduced, and assembly with another device is facilitated.

FIG. 21 is another structural packaging diagram of a low noise amplifier according to an embodiment of this application.

As shown in FIG. 21, in an embodiment provided in this application, the low noise amplifier includes a power supply and load switching circuit 241, a low noise amplification module 242, a second carrier board 245, a second chip 246, and a third chip 247. The low noise amplification module 242 and the power supply and load switching circuit 241 are respectively integrated on the second chip 246 and the third chip 247. The second chip 246 and the third chip 247 are arranged on the second carrier board 245.

In this embodiment of this application, the low noise amplification module 242 and the power supply and load switching circuit 241 may be respectively integrated on the second chip 246 and the third chip 247 by using different semiconductor processes, and the second chip 246 and the third chip 247 each are arranged on the second carrier board 245, so that the low noise amplification module 242 and the power supply and load switching circuit 241 are interconnected to another electronic component through the second carrier board 245, to implement a low noise amplification function during radio frequency reception. The low noise amplification module 242 and the power supply and load switching circuit 241 are respectively integrated on different chips, so that modification or replacement of the low noise amplification module 242 and the power supply and load switching circuit 241 may be facilitated.

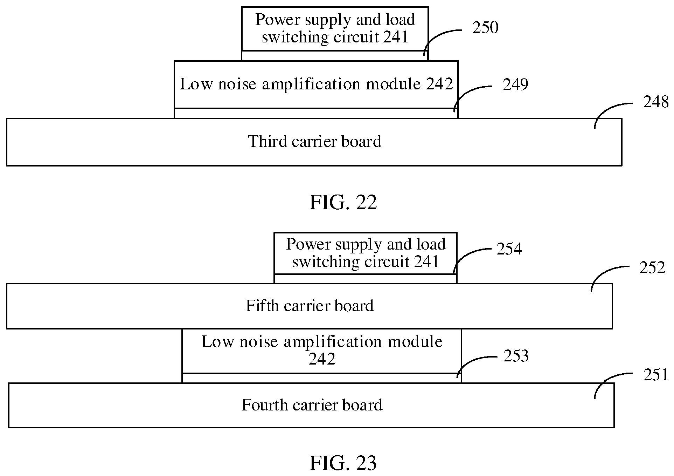

FIG. 22 is another structural packaging diagram of a low noise amplifier according to an embodiment of this application.

As shown in FIG. 22, in an embodiment provided in this application, the low noise amplifier includes a power supply and load switching circuit 241, a low noise amplification module 242, a third carrier board 248, a fourth chip 249, and a fifth chip 250. The low noise amplification module 242 and the power supply and load switching circuit 241 are respectively integrated on the fourth chip 249 and the fifth chip 250. The fourth chip 249 and the fifth chip 250 are stacked on the third carrier board 248.

In this embodiment of this application, the low noise amplification module 242 and the power supply and load switching circuit 241 may be respectively integrated on the fourth chip 249 and the fifth chip 250 by using different semiconductor processes, and the fourth chip 249 and the fifth chip 250 are stacked on the third carrier board 248, so that the low noise amplification module 242 and the power supply and load switching circuit 241 are interconnected to another electronic component through the third carrier board 248, to implement a low noise amplification function during radio frequency reception. Exemplarily, chips with large areas in the fourth chip 249 and the fifth chip 250 are arranged close to the third carrier board 248. The low noise amplification module 242 and the power supply and load switching circuit 241 are stacked and jointly integrated on the same carrier board, so that a volume of the low noise amplifier may be reduced.

FIG. 23 is another structural packaging diagram of a low noise amplifier according to an embodiment of this application.

As shown in FIG. 23, in an embodiment provided in this application, the low noise amplifier includes a power supply and load switching circuit 241, a low noise amplification module 242, a fourth carrier board 251, a fifth carrier board 252, a sixth chip 253, and a seventh chip 254. The low noise amplification module 242 and the power supply and load switching circuit 241 are respectively integrated on the sixth chip 253 and the seventh chip 254. The sixth chip 253 is arranged on the fourth carrier board 251. The seventh chip 254 is arranged on the fifth carrier board 252. The fourth carrier board 251 and the fifth carrier board 252 are stacked.

In this embodiment of this application, the low noise amplification module 242 and the power supply and load switching circuit 241 may be respectively integrated on the sixth chip 253 and the seventh chip 254 by using different semiconductor processes, the sixth chip 253 is arranged on the fourth carrier board 251, the seventh chip 254 is arranged on the fifth carrier board 252, and the fourth carrier board 251 and the fifth carrier board 252 are stacked, so that the low noise amplification module 242 and the power supply and load switching circuit 241 are interconnected to another electronic component through the fourth carrier board 251 and the fifth carrier board 252, to implement a low noise amplification function during radio frequency reception. The low noise amplification module 242 and the power supply and load switching circuit 241 are respectively stacked on different carrier boards, so that modification or replacement of the low noise amplification module 242 and the power supply and load switching circuit 241 may be facilitated.

An embodiment of this application further provides an electronic device, including the foregoing plurality of low noise amplifiers. The low noise amplifier includes the foregoing power supply and load switching circuit. At least four performance modes with different linearity and power consumption may be obtained by switching different power paths of at least two power supplies, and at least two performance modes of different operating bands may be obtained by switching different impedance values of at least two loads, to enable the low noise amplifier to obtain more different performance modes.

It should be understood that, the foregoing is merely an example for a structure of the electronic device 100, and the electronic device 100 may alternatively include another subsystem or device. For details, settings and modifications may be performed based on requirements. This is not limited in the embodiments of this application.

For beneficial effects that can be achieved by the electronic device provided in this embodiment of this application, refer to the beneficial effects corresponding to the module provided above. Details are not described herein again.

It should be understood that, the following are intended to help a person skilled in the art to better understand the embodiments of this application, but not to limit the scope of the embodiments of this application. Apparently, the person skilled in the art can make various equivalent modifications or changes based on the examples provided above. For example, some steps in each embodiment of the above detection method may not be necessary, or some new steps may be added. Alternatively, the foregoing any two or more embodiments may be combined. Solutions of such modifications, changes, or combination also fall within the scope of the embodiments of this application. In addition, the shown or discussed mutual couplings or direct couplings or communication connections may be implemented through some interfaces. The indirect couplings or communication connections between the apparatus or units may be implemented in electronic, mechanical, or other forms.

The units described as separate components may or may not be physically separated. The components displayed as units may or may not be physical units, and may be located in one position, or may be distributed on a plurality of network units. Some or all of the units may be selected according to actual needs to achieve the objectives of the solutions of the embodiments.

In addition, functional units in the embodiments of this application may be integrated into one processing unit, or each of the units may exist alone physically, or two or more units may be integrated into one unit.

It should be further understood that, the foregoing descriptions of the embodiments of this application focus on emphasizing differences between the embodiments. For the same or similar description not mentioned, reference may be made to each other. For brevity, details are not described herein again.

It should be further understood that sequence numbers of the foregoing processes do not mean execution sequences in various embodiments of this application. The execution sequences of the processes should be determined according to functions and internal logic of the processes, and should not be construed as any limitation on the implementation processes of the embodiments of this application.

It should be further understood that in the embodiments of this application, "preset" and "predefined" can be achieved by pre-saving corresponding code or tables or in another manner that may be used for indicating relevant information in a device (for example, including an electronic device), and specific implementations are not limited in this application.

It should be further understood that, the division of manners, cases, and categories in the embodiments of this application is merely for ease of description, and should not be construed as a particular limitation. Features in various manners, categories, cases, and the embodiments can be combined without contradiction.

It is to be understood that, in the embodiments of this application, unless otherwise specified and there is a logical conflict, terms and/or descriptions in different embodiments are consistent and may be referenced by each other. Technical features in different embodiments may be combined based on an internal logical relationship thereof to form a new embodiment.

Finally, it should be noted that: the foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be based on the protection scope of the claims. In conclusion, the foregoing description is merely exemplary embodiments of this application, and is not intended to limit the protection scope of this application. Any modification, equivalent replacement, improvement and the like made within the spirit and principle of this application shall fall within the protection scope of this application.

## Claims

1. A power supply and load switching circuit, comprising at least two power supplies, a toggle switch, at least two loads, and at least two output ports, wherein
at least two ports of the toggle switch are respectively electrically connected to the at least two power supplies, and at least two other ports of the toggle switch are respectively electrically connected to the at least two output ports, to switch on at least four power paths; and
the at least two loads are respectively arranged on paths between the at least two power supplies and the at least two output ports, to adjust load impedance values of the at least four power paths.

2. The power supply and load switching circuit according to claim 1, wherein the at least two loads comprise a first load inductor and a second load inductor; and
the first load inductor and the second load inductor are respectively arranged on paths between the at least two power supplies and the toggle switch.

3. The power supply and load switching circuit according to claim 2, wherein a coupling relationship exists between the first load inductor and the second load inductor.

4. The power supply and load switching circuit according to any one of claims 1 to 3, wherein the at least two loads comprise a third load inductor and a fourth load inductor; and
the third load inductor and the fourth load inductor are respectively arranged on paths between the toggle switch and the at least two output ports.

5. The power supply and load switching circuit according to claim 4, wherein a coupling relationship exists between the third load inductor and the fourth load inductor.

6. The power supply and load switching circuit according to claim 1, wherein the at least two loads comprise a first load inductor, a second load inductor, a third load inductor, and a fourth load inductor; and
the first load inductor and the second load inductor are respectively arranged on paths between the at least two power supplies and the toggle switch, the third load inductor and the fourth load inductor are respectively arranged on paths between the toggle switch and the at least two output ports, and a coupling relationship exists between any two of the first load inductor, the second load inductor, the third load inductor, and the fourth load inductor.

7. The power supply and load switching circuit according to any one of claims 1 to 3, wherein the at least two power supplies comprise a first power supply and a second power supply; and
the first power supply and the second power supply are respectively electrically connected to the at least two ports of the toggle switch, and a voltage value of the first power supply is greater than a voltage value of the second power supply.

8. The power supply and load switching circuit according to claim 7, wherein the toggle switch comprises a double pole double throw switch, and the at least two output ports comprise a first output port and a second output port; and
two ports of the double pole double throw switch are respectively electrically connected to the first power supply and the second power supply, and other two ports of the double pole double throw switch are respectively electrically connected to the first output port and the second output port.

9. The power supply and load switching circuit according to claim 8, wherein two switch paths connected to the double pole double throw switch and the first power supply are respectively connected to m switch devices in parallel, two switch paths connected to the double pole double throw switch and the second power supply are respectively connected to n switch devices in parallel, and m≥n.

10. A low noise amplifier, comprising the power supply and load switching circuit according to any one of claims 1 to 9.

11. The low noise amplifier according to claim 10, wherein the low noise amplifier further comprises a low noise amplification module; and
the low noise amplification module is electrically connected to the power supply and load switching circuit, to perform low noise amplification on an input signal.

12. The low noise amplifier according to claim 11, wherein the low noise amplification module comprises a first amplifier, a second amplifier, a bias circuit, and a controller;
the power supply and load switching circuit is electrically connected to the first amplifier, the second amplifier, and the controller separately, and both the first amplifier and the second amplifier are electrically connected to the bias circuit;
the first amplifier is configured to amplify a first input signal;
the second amplifier is configured to amplify a second input signal;
the bias circuit is configured to provide a bias voltage to the first amplifier and the second amplifier; and
the controller is configured to provide a mode switch signal to the power supply and load switch module.

13. The low noise amplifier according to claim 12, wherein the first amplifier comprises a first transistor, a second transistor, a first input inductor, a first source inductor, a first input port, and a first output port; the bias circuit outputs a first bias voltage and a second bias voltage; and
a gate of the first transistor is connected to the first input port through the first input inductor, a source of the first transistor is grounded through the first source inductor, a drain of the first transistor is electrically connected to a source of the second transistor, a drain of the second transistor is electrically connected to the first output port, the first bias voltage is applied to the gate of the first transistor, and the second bias voltage is applied to a gate of the second transistor.

14. The low noise amplifier according to claim 13, wherein the first amplifier further comprises a first bias network and a second bias network; and
the first bias network is connected between the gate of the first transistor and the first bias voltage, and the second bias network is connected between the second transistor and the second bias voltage.

15. The low noise amplifier according to claim 13, wherein the first amplifier further comprises a first input capacitor, a first gate bias capacitor, and a first output capacitor; and
the first input capacitor is connected between the gate of the first transistor and the first input inductor, the first gate bias capacitor is connected between the gate of the second transistor and a ground end, and the first output capacitor is connected between the drain of the second transistor and the first output port.

16. The low noise amplifier according to claim 13, wherein the first amplifier further comprises a fifth switch and a sixth switch; and
the fifth switch is connected between the gate of the second transistor and a ground end, the sixth switch is connected between the gate of the second transistor and the second bias voltage, and the fifth switch and the sixth switch are separately electrically connected to the controller.

17. The low noise amplifier according to claim 16, wherein the first amplifier further comprises a first auxiliary path; and
two ends of the first auxiliary path are respectively electrically connected to the source of the second transistor and the gate of the second transistor, and the first auxiliary path is further electrically connected to the controller.

18. The low noise amplifier according to any one of claims 12 to 17, wherein the second amplifier comprises a third transistor, a fourth transistor, a second input inductor, a second source inductor, a second input port, and a second output port; the bias circuit outputs a third bias voltage and a fourth bias voltage; and
a gate of the third transistor is connected to the second input port through the second input inductor, a source of the third transistor is grounded through the second source inductor, a drain of the third transistor is electrically connected to a source of the fourth transistor, a drain of the fourth transistor is electrically connected to the second output port, the third bias voltage is applied to the gate of the third transistor, and the fourth bias voltage is applied to a gate of the fourth transistor.

19. The low noise amplifier according to claim 18, wherein the second amplifier further comprises a third bias network and a fourth bias network; and
the third bias network is connected between the gate of the third transistor and the third bias voltage, and the fourth bias network is connected between the fourth transistor and the fourth bias voltage.

20. The low noise amplifier according to claim 18, wherein the second amplifier further comprises a second input capacitor, a second gate bias capacitor, and a second output capacitor; and
the second input capacitor is connected between the gate of the third transistor and the second input inductor, the second gate bias capacitor is connected between the gate of the fourth transistor and the ground end, and the second output capacitor is connected between the drain of the fourth transistor and the second output port.

21. The low noise amplifier according to claim 18, wherein the second amplifier further comprises a seventh switch and an eighth switch; and
the seventh switch is connected between the gate of the fourth transistor and the ground end, the eighth switch is connected between the gate of the fourth transistor and the fourth bias voltage, and the seventh switch and the eighth switch are separately electrically connected to the controller.

22. The low noise amplifier according to claim 21, wherein the second amplifier further comprises a second auxiliary path; and
two ends of the second auxiliary path are respectively electrically connected to the source of the fourth transistor and the gate of the fourth transistor, and the second auxiliary path is further electrically connected to the controller.

23. The low noise amplifier according to claim 11, wherein the low noise amplifier further comprises a first carrier board and a first chip; and
the low noise amplification module and the power supply and load switching circuit are jointly integrated on the first chip, and the first chip is arranged on the first carrier board.

24. The low noise amplifier according to claim 11, wherein the low noise amplifier further comprises a second carrier board, a second chip, and a third chip; and
the low noise amplification module and the power supply and load switching circuit are respectively integrated on the second chip and the third chip, and the second chip and the third chip are arranged on the second carrier board.

25. The low noise amplifier according to claim 11, wherein the low noise amplifier further comprises a third carrier board, a fourth chip, and a fifth chip; and
the low noise amplification module and the power supply and load switching circuit are respectively integrated on the fourth chip and the fifth chip, and the fourth chip and the fifth chip are stacked on the third carrier board.

26. The low noise amplifier according to claim 11, wherein the low noise amplifier further comprises a fourth carrier board, a fifth carrier board, a sixth chip, and a seventh chip; and
the low noise amplification module and the power supply and load switching circuit are respectively integrated on the sixth chip and the seventh chip, the sixth chip is arranged on the fourth carrier board, the seventh chip is arranged on the fifth carrier board, and the fourth carrier board and the fifth carrier board are stacked.

27. An electronic device, comprising the low noise amplifier according to any one of claims 10 to 26, wherein the low noise amplifier is configured to receive a signal.

28. The power supply and load switching circuit according to claim 1, comprising at least two power supplies, a toggle switch, at least two loads, and at least two output ports, wherein
at least two ports of the toggle switch are respectively electrically connected to the at least two power supplies, and at least two other ports of the toggle switch are respectively electrically connected to the at least two output ports, to switch on at least four power paths;
the at least two loads are respectively arranged on paths between the at least two power supplies and the at least two output ports, to adjust load impedance values of the at least four power paths;
the at least four power paths comprise: a path between one power supply and one output port, a path between the power supply and another output port, a path between another power supply and the one output port, and a path between the another power supply and the another output port;
the at least two loads comprise a first load inductor, a second load inductor, a third load inductor, and a fourth load inductor; and
the first load inductor and the second load inductor are respectively arranged on paths between the at least two power supplies and the toggle switch, the third load inductor and the fourth load inductor are respectively arranged on paths between the toggle switch and the at least two output ports, and a coupling relationship exists between any two of the first load inductor, the second load inductor, the third load inductor, and the fourth load inductor.

29. The power supply and load switching circuit according to claim 28, wherein the at least two power supplies comprise a first power supply and a second power supply; and
the first power supply and the second power supply are respectively electrically connected to the at least two ports of the toggle switch, and a voltage value of the first power supply is greater than a voltage value of the second power supply.

30. The power supply and load switching circuit according to claim 29, wherein the toggle switch comprises a double pole double throw switch, and the at least two output ports comprise a first output port and a second output port; and
two ports of the double pole double throw switch are respectively electrically connected to the first power supply and the second power supply, and other two ports of the double pole double throw switch are respectively electrically connected to the first output port and the second output port.

31. The power supply and load switching circuit according to claim 30, wherein two switch paths connected to the double pole double throw switch and the first power supply are respectively connected to m switch devices in parallel, two switch paths connected to the double pole double throw switch and the second power supply are respectively connected to n switch devices in parallel, and m≥n.
